# EUROPÄISCHE PATENTSCHRIFT

(11) **EP 3 610 500 B1**
(45) Veröffentlichungstag und Bekanntmachung des Hinweises auf die Patenterteilung: **31.03.2021**
(21) Anmeldenummer: 17726196.3
(22) Anmeldetag: 11.04.2017
(51) Int. Cl.: H01L 21/68, H01L 21/677, H05K 13/04, H05K 13/02, H01L 21/67, H05K 13/08

(54) **BAUTEIL-EMPFANGSEINRICHTUNG MIT OPTISCHEM SENSOR**
COMPONENT RECEPTION APPARATUS WITH OPTICAL SENSOR
APPAREIL DE RÉCEPTION DE COMPOSANT AVEC CAPTEUR OPTIQUE

(43) Veröffentlichungstag der Anmeldung: 19.02.2020
(73) Patentinhaber: Mühlbauer GmbH & Co. KG, 93426 Roding (DE)
(72) Erfinder: KOCH, Konstantin, 93426 Roding (DE)
(74) Vertreter: Schmidt, Steffen J.
(86) Internationale Anmeldenummer: PCT/EP2017/058655
(87) Internationale Veröffentlichungsnummer: WO 2018/188731

(56) Entgegenhaltungen:
- WO-A1-03/058708
- CN-A- 104 752 283
- DE-A1-102004 051 301
- DE-B3-102015 013 494
- JP-A- H11 295 236
- US-A- 5 249 356
- US-A- 5 547 537
- US-A1- 2004 036 041
- US-B1- 6 519 838

## Beschreibung

### Hintergrund

Hier wird eine Empfangseinrichtung für Bauteile beschrieben. Diese Empfangseinrichtung ist im Zusammenwirken mit einer Bauteilhandhabungsvorrichtung sowie einem bildgebenden Sensor erläutert.

Ein Bauteil ist hier zum Beispiel ein (elektronisches) Halbleiterbauteil, auch als "chip" oder "die" bezeichnet. Ein solches Bauteil hat in der Regel eine prismatische Gestalt, einen im Wesentlichen polygonalen, zum Beispiel viereckigen (rechteckförmigen oder quadratischen) Querschnitt mit mehreren Mantelflächen sowie eine Stirnfläche und eine Deckfläche. Die Mantelflächen sowie die beiden (untere und obere) Deckflächen des Bauteils sind nachfolgend allgemein als Seitenflächen bezeichnet. Das Bauteil kann auch eine von vier abweichende Anzahl von Mantelflächen haben. Ein Bauteil kann auch eine optisches Bauteil (Prisma, Spiegel, Linse, etc.) sein. Insgesamt kann ein Bauteil jede geometrische Form haben.

Aus der betrieblichen Praxis der Anmelderin sind so genannte Aufnehm- und Absetzvorrichtungen bekannt, in denen Bauteile mittels eines Saugers oder Festhalters von einem Bauteiltisch aufgenommen und anschließend auf einem Träger oder in einem Transportbehälter oder dergl. abgelegt werden. Vor dem Ablegen des Bauteils findet üblicherweise eine Inspektion des Bauteils statt. Dazu werden Abbildungen einer oder mehrerer Seitenflächen des Bauteils mit einer oder mehreren Kameras aufgenommen und mittels automatisierter Bildverarbeitung ausgewertet.

### Stand der Technik

Derartige Festhalter halten ein Bauteil während des Transports und während der Erfassung eines Bildes von einer, zum Beispiel der unteren, Deckfläche des Bauteiles fest. So zeigt die DE 10 2008 018 586 A1 eine optische Erfassungsvorrichtung für die Erfassung von einer Oberfläche eines Bauteils, das von einer ersten zu einer zweiten Arbeitsstation transportiert wird, eine auf mindestens eine erste Oberfläche des Bauteils gerichtete Kamera, eine Lichtquelle, die kurzwellige Lichtstrahlen zur ersten Oberfläche sendet. Eine zweite Lichtquelle sendet langwellige Lichtstrahlen zu mindestens einer zweiten Oberfläche des Bauteils. Die Kamera empfängt die an den Oberflächen reflektierten ersten und zweiten Lichtstrahlen. Die zweite(n) Oberfläche(n) sind gegenüber der/den ersten Oberfläche(n) unterschiedlich orientiert, wie es bei beispielsweise quaderförmigen Bauteilen mit einer Unterseite und insgesamt vier seitlichen Oberflächen der Fall ist.

Die EP 1 470 747 B1 betrifft eine Chipentnahmevorrichtung, ein Chipentnahmesystem, ein Bestückungssystem sowie ein Verfahren zum Entnehmen und Weiterverarbeiten von Chips. Die Chips werden von einem Wafer entnommen und zu einer Übergabeposition transportiert und gleichzeitig gewendet. Diese Chipentnahmevorrichtung zum Entnehmen von Chips von strukturierten Halbleiter-Wafern ist ausgestattet mit einem drehbaren Entnahmewerkzeug zum Entnehmen der Chips von dem Wafer und zum Wenden der entnommenen Chips um 180° um ihre Längs- oder Querachse, und einem drehbaren Wendewerkzeug zum erneuten Wenden der entnommenen Chips um 180° um ihre Längs- oder Querachse, welches mit dem Entnahmewerkzeug zusammenwirkt. Das Entnahmewerkzeug hat eine erste Übergabeposition und das Wendewerkzeug hat eine zweite Übergabeposition, an welchen die Chips zur Weiterverarbeitung an einen Bestückkopf übergebbar sind.

Die EP 0 906 011 A2 betrifft eine Vorrichtung zum Entnehmen und Bestücken von elektrischen Bauelementen auf einem Substrat. Die Vorrichtung umfasst eine drehbare Übergabeeinrichtung, die an einer Aufnahmeposition die elektrischen Bauelemente aus einem Zuführmodul entnimmt und an einer ersten Übergabeposition einem Saugband zur Weiterverarbeitung übergibt. Mittels eines drehbaren Bestückkopfes werden die Bauelemente von dem Saugband aufgenommen und zu einer zweiten Ubergabeposition transportiert.

Das Dokument DE10 2015 013 494 B3 zeigt eine Vorrichtung zum Überprüfen und Umdrehen elektronischer Bauelemente, insbesondere Flipchips, mit einem an einem Drehpunkt drehbar gelagerten Bauteil zum Umdrehen der elektronischen Bauelemente, wobei an dem Bauteil außenseitig ein erstes Aufnahmeelement zum Aufnehmen eines einzelnen elektronischen Bauelementes von einem Träger und dessen Festhalten während einer Drehbewegung des Bauteils befestigt ist, wobei ein zweites Aufnahmeelement dem ersten Aufnahmeelement bezüglich dem Drehpunkt gegenüberliegend derart außenseitig an dem Bauteil angeordnet ist, dass jeweils ein Aufnahmeelement bei jeder Drehung des Bauteils um 180° dem Träger zugewandt ist und dass in dem Bauteil zwischen den Aufnahmeelementen eine Durchgangsöffnung derart angeordnet ist, dass die Durchgangsöffnung bei einer Drehung des Bauteils um 90° oder 270° dem Träger zugewandt ist.

Die WO 02/054480 A1 betrifft eine Vorrichtung zum optischen Inspizieren verschiedener Oberflächen eines zu montierenden Chips. Die Vorrichtung umfasst eine erste, obere Transportscheibe, die dazu eingerichtet ist, die Chips aus einer Zuführeinheit zu entnehmen und zu einer ersten Übergabeposition zu transportieren. Die Chips werden in Saugöffnungen gehalten, welche an der Mantelfläche der oberen Transporttrommel ausgebildet sind, und durch Drehen der oberen Transportscheibe bewegt. Die Vorrichtung weist weiterhin eine entsprechend der oberen Transportscheibe ausgebildete zweite, untere Transportscheibe auf, welche die entnommenen Chips an der ersten Übergabeposition aufnimmt und zu einer zweiten Übergabeposition transportiert. Die Vorrichtung ermöglicht eine Inspektion der Chips, indem seitlich neben den Transportscheiben Kameras angeordnet sind, die die Chips an deren Ober- und Unterseite inspizieren. Die Chips werden weiterhin relativ zur ursprünglichen Ausrichtung ungewendet an eine Sortiervorrichtung zur Weiterverarbeitung übergeben.

Die US 4,619,043 offenbart eine Vorrichtung und ein Verfahren zum Entnehmen und Anbringen von elektronischen Bauteilen, insbesondere Chips, auf einer Leiterplatte. Die Vorrichtung umfasst ein Beförderungsmittel zum Aufnehmen der Chips in Aufnahmeeinheiten und zum Transprotieren der aufgenommenen Chips zu einer ersten Übergabeposition. Das Beförderungsmittel weist dabei eine Beförderungskette und ein drehbares Kettenrad auf, welche zusammen im Eingriff stehen. Die Vorrichtung umfasst weiterhin ein drehbares Befestigungswerkzeug mit Bestückköpfen zum Aufnehmen der Chips an der ersten Übergabeposition. Das Befestigungswerkzeug ist weiterhin dazu eingerichtet, mittels einer Drehbewegung die aufgenommenen Chips zu einer zweiten Übergabeposition zu befördern, wobei sie gewendet werden.

Die JP 2-193813 betrifft eine Vorrichtung zum Aufnehmen und zum Wenden von elektronischen Komponenten, welche durch Prüfvorrichtungen inspiziert werden. Die Vorrichtung umfasst eine Zufuhreinheit, aus welcher chipartige elektronische Bauteile durch einen ersten rotierenden Körper entnommen und an dessen Umfang angeordnet werden. Durch eine Drehbewegung des rotierenden Körpers werden die elektronischen Bauteile zu einer ersten Übergabeposition transportiert, wodurch diese um ihre Längs- oder Querachse gewendet werden. Die Vorrichtung umfasst weiterhin einen zweiten rotierenden Körper, welcher die entnommenen elektronischen Bauteile an der ersten Übergabeposition aufnimmt und zu einer zweiten Übergabeposition transportiert. Dabei erfolgt ein weiteres Wenden der elektronischen Bauteile um deren Längs- oder Querachse. Die Vorrichtung ermöglicht somit, dass unterschiedliche Seiten der Bauteile inspiziert werden.

Die US 6,079,284 betrifft eine Vorrichtung zum umfangreichen visuellen Inspizieren von Tabletten. Die Vorrichtung umfasst eine erste Inspektionstrommel, welche mittels an deren Mantelfläche ausgebildeten Sauglochbohrungen die Tabletten aus einer Zuführvorrichtung entnimmt und diese durch Drehen zu einer zweiten Inspektionstrommel transportiert. Die zweite Trommel ist entsprechend der ersten Trommel mit Sauglochbohrungen ausgebildet, welche die Tabletten an der Übergabeposition aufnehmen. Die Vorrichtung umfasst weiterhin Inspektionseinheiten, welche eine umfassende Inspizierung der Tabletten ermöglichen.

Weiterer technologischer Hintergrund ist den Dokumenten JP 2001-74664 (A), JP 1-193630 (A), US 5,750,979, WO 85/04385 A1, DE 199 13 134 A1, JP 8-227904 A zu entnehmen.

### Zu lösendes Problem

Eine Empfangseinrichtung für Bauteile soll eine präzise Handhabung von Bauteilen sowie deren Inspektion bei hohem Durchsatz ermöglichen.

### Hier vorgestellte Lösung

Diese Aufgabe löst eine Empfangseinrichtung für Bauteile, die dazu eingerichtet ist, relativ zu einer Ablagestelle mittels wenigstens eines Linearantriebes zumindest teilweise längs einer ersten, zweiten und/oder dritte Achsen kontrolliert verstellt zu werden und/oder mittels eines Antriebes einen durch die Empfangseinrichtung geführten Träger längs einer der ersten und/oder zweiten Achsen kontrolliert zu verfahren. Die Empfangseinrichtung weist einen Lagesensor auf, der einer Bauteil-Ablagestelle zugeordnet ist um ein verkipptes oder verdrehtes, nur teilweise in einer Tasche des Trägers abgelegtes Bauteil in der Bauteil-Ablagestelle zu erfassen, wobei der Lagesensor seitlich zum Träger mit der Empfangseinrichtung derart verbunden ist, dass der Lagesensor Bewegungen der Empfangseinrichtung unmittelbar mit ausführt.

Der Empfangseinrichtung für Bauteile ist in einer Variante funktional vorgeschaltet eine Bauteilhandhabungsvorrichtung zum Entnehmen von prismatischen Bauteilen von einem strukturierten Bauteilvorrat und zum Ablegen der entnommenen Bauteile an einer Empfangseinrichtung. Eine erste Wendeeinrichtung mit mehreren Aufnehmern ist dazu eingerichtet, an einer Spendestelle ein Bauteil von dem strukturierten Bauteilvorrat zu empfangen, das empfangene Bauteil um einen ersten vorbestimmten Winkel um seine Längs- oder Querachse zu wenden und zu einer Übergabestelle zu fördern. Eine zweite Wendeeinrichtung mit mehreren Aufnehmern ist dazu eingerichtet, das Bauteil an der Übergabestelle von einem Aufnehmer der ersten Wendeeinrichtung zu empfangen, das empfangene Bauteil um einen zweiten vorbestimmten Winkel um seine Längs- oder Querachse zu wenden und zu einer Ablagestelle zu fördern. Den ersten und zweiten Wendeeinrichtungen zugeordnete Lage- und Eigenschaftssensoren sind dazu eingerichtet, Lagedaten der ersten und zweiten Wendeeinrichtungen, Lagedaten von an den Aufnehmern befindlichen Bauteilen, und/oder Eigenschaften von an den Aufnehmern befindlichen Bauteilen zu erfassen, und für eine Steuerung zur Verfügung zu stellen. Die Steuerung ist dazu eingerichtet, mittels eines ersten Drehantriebes die erste Wendeeinrichtung um eine erste Achse kontrolliert zu drehen, mittels eines ersten Linearantriebes die erste Wendeeinrichtung längs der ersten Achse kontrolliert zu verfahren, mittels eines zweiten Drehantriebes die zweite Wendeeinrichtung um eine zu der ersten Achse nicht kollineare zweite Achse kontrolliert zu drehen, und mittels eines zweiten Linearantriebes die zweite Wendeeinrichtung längs der zweiten Achse kontrolliert zu verfahren.

So bildet die hier vorgestellte Anordnung eine integrierte Empfangseinrichtung/Inspektionseinrichtung für Bauteile. Die Begriffe Empfangsstelle und (Ablage-)Tasche werden hier gleichbedeutend verwendet. Schlechtteile können dabei ausgeschleust werden. Die in den Übergabevorgang integrierte optische Untersuchung des Bauteils gliedert sich in mehrere Untersuchungsvorgänge auf. Sie nutzt einen oder mehrere bildgebende Sensoren zum optischen Erfassen von Deck- und/ oder Mantelfläche(n) eines Bauteils sowie der Positionen der Aufnehmer an den Übergabe-/ Empfangsstellen. Diese bildgebenden Sensoren sind dazu eingerichtet, in mehreren Untersuchungsvorgängen jeweils wenigstens ein Bild einer der Deck- und/ oder Mantelflächen eines Bauteils zu erfassen. Die Förderung / der Transport der Bauteile geschieht, während Aufnehmer von Wendeeinrichtungen jeweils ein Bauteil halten. Ein gehaltenes Bauteil passiert während des Transports einzelne Untersuchungsvorgänge. Die erfassten (Bild-)Daten der bildgebenden Sensoren dienen dabei auch dazu, die Positionsregelung der Manipulatoren (Aufnehmer) und der Empfangsstellen zu koordinieren. Die Bauteilförderung ist dazu eingerichtet, ein Bauteil im Wesentlichen kontinuierlich oder getaktet entlang seines Pfades zu fördern.

Die hier vorgestellte komplette Baugruppe vereint funktional zwei Aspekte: Handhabung und Inspektion. Diese beiden Funktionen werden zur schnellen und präzisen qualitativen Beurteilung mehrerer (bis zu sechs oder mehr) Seiten der Bauteile ineinander verwoben, während diese schnell aus dem Bauteilvorrat vereinzelt entnommen und durch die Inspektion als Gutteile klassifiziert an der oder den Empfangsstellen präzise abgesetzt werden.

Die Bauteilhandhabungsvorrichtung hat zwei vorzugsweise geregelt betriebene, vorzugsweise im Wesentlichen orthogonal (90° plus minus bis zu 15°) zueinander angeordnete, in etwa stern- oder radförmige Wendeeinrichtungen. Die Wendeeinrichtungen könnten auch eine rechteckige Gestalt haben. Jede dieser Wendeeinrichtungen trägt mehrere zu ihrer Drehachse radial verfahrbare Aufnehmer, um die Bauteile jeweils auf einem Aufnehmer fixiert innerhalb eines Schwenkwinkels zwischen Bauteil-Übernahme und -Übergabe einer oder mehreren Prozessstationen zur Inspektion, Schlechtteilausschleusung und ggf. weiteren Stationen zuzuführen.

Bei der hier vorgestellten Bauteilhandhabungsvorrichtung tragen die stern- oder radförmigen Wendeeinrichtungen die Bauteile an radial nach außen weisenden Aufnehmern, die am (gedachten) Umfang der beiden Wendeeinrichtungen angeordnet sind. Dies ist im Unterschied zu solchen Bauteilhandhabungsvorrichtungen zu sehen, bei denen die Aufnehmer einer oder beider Wendeeinrichtungen koplanar oder parallel zur deren Rotationsachse orientiert sind.

Während vorstehend mehrere Untersuchungsvorgänge erwähnt sind, soll damit kein zeitlicher Ablauf oder eine Reihenfolge (zuerst eine Bilderfassung in einem ersten und dann eine Bilderfassung in einem weiteren Untersuchungsvorgang) festgelegt sein. Vielmehr sind auch Fälle denkbar, in denen die umgekehrte Reihenfolge günstiger ist. Da abhängig von der Anzahl der Aufnehmer an den einzelnen Wendeeinrichtungen auch gleichzeitig mehrere Bauteile an jeder der Wendeeinrichtungen aufgenommen sein können, finden die Untersuchungsvorgänge auch zeitgleich, wenn auch an unterschiedlichen Bauteilen, statt.

Die in den einzelnen Untersuchungsvorgängen durch die bildgebenden Sensoren erfasste(n) (oberen/unteren) Deck- und/oder (seitlichen) Mantelfläche(n) eines Bauteils können voneinander abweichende Deck- und/oder Mantelflächen des Bauteils sein.

Ein Aspekt der optischen Untersuchung sieht vor, dass die Bauteilförderung mit einem Bauteil den Bauteilpfad im Wesentlichen ohne oder nahezu ohne Stillstand absolviert. Dabei werden während der Bewegung oder während der minimalen Stillstandszeiten eine oder mehrere Deck- und/oder Mantelflächen eines Bauteils mit den bildgebenden Sensoren erfasst. Diese Bilder werden anschließend mit Methoden der Bildverarbeitung ausgewertet. Eine Variante dieser optischen Erfassung / Untersuchung sieht vor, dass als bildgebende Sensoren eine oder mehrere Farb-Kameras oder Schwarzweiß-Kameras vorgesehen sind.

Die bildgebenden Sensoren können dabei einen oder mehrere Spiegel, optische Prismen, Linsen oder dergl. haben.

Den bildgebenden Sensoren können Strahlungs- oder Lichtquellen zugeordnet sein. Dabei kann jede Quelle dazu eingerichtet sein, Licht / Strahlung mit einem unterschiedlichen Spektral- oder Wellenlängenbereich zur Beleuchtung zumindest eines Abschnitts des Bauteils abzugeben. Die Wellenlängenbereiche können zumindest teilweise voneinander abweichen, überlappen oder übereinstimmen. So kann zum Beispiel das Licht der ersten Lichtquelle rot, und das Licht der zweiten Lichtquelle kann blau sein. Es kann aber auch die umgekehrte Zuordnung oder eine andere Wellenlängenpaarung (zum Beispiel infrarotes und sichtbares Licht) gewählt sein.

Die Lichtquellen können durch eine Steueranordnung in dem Moment jeweils kurz eingeschaltet werden, wenn sich der Aufnehmer mit dem Bauteil im jeweiligen Erfassungsbereich befindet, so dass die Deck- und/oder Mantelflächen des Bauteils mit einem kurzen Lichtblitz zur Erfassung durch den jeweiligen bildgebenden Sensor belichtet werden können. Alternativ kann eine dauerhafte Beleuchtung verwendet werden.

Der Bauteilhandhabungsvorrichtung ist in einer Variante eine Abgabeeinrichtung zugeordnet, die dazu eingerichtet ist, jeweils ein Bauteil aus dem strukturierten Bauteilvorrat an einen durch die Steuerung entsprechend positionierten Aufnehmer der ersten Wendeeinrichtung abzugeben. Dies kann ein Bauteil-Ausstoßer (die ejector) sein, der das Bauteil durch die Waferträgerfolie hindurch mittels einer Nadel abstößt oder ein Laserpulsgeber, der den Haftkleber des Bauteils an der Trägerfolie gezielt zum Schmelzen bringt. Der Abgabeeinrichtung ist ein Lage- und/oder Eigenschaftssensor zugeordnet, der dazu eingerichtet ist, die Lage der Abgabeeinrichtung relativ zu dem abzugebenden Bauteil und/oder Lagedaten des abzugebenden Bauteils, und/oder Eigenschaften des abzugebenden Bauteils zu erfassen und für die Steuerung zum Betätigen der Abgabeeinrichtung zur Verfügung zu stellen.

Der Bauteilhandhabungsvorrichtung ist in einer Variante mit einer der Ablagestelle zugeordneten Empfangseinrichtung für ein dorthin gefördertes Bauteil ausgestattet. Der Empfangseinrichtung sind dabei Lage- und/oder Eigenschaftssensoren zugeordnet, die dazu eingerichtet sind, Lagedaten des an die Ablagestelle geförderten Bauteils, Lagedaten und/oder Eigenschaften von Empfangsstellen in der Empfangseinrichtung und/oder darin befindlichen Bauteils zu erfassen und für eine Steuerung zur Verfügung zu stellen. Die Steuerung ist dazu eingerichtet, mittels eines dritten Drehantriebes die Empfangseinrichtung zumindest teilweise um eine die Ablagestelle enthaltende dritte Achse kontrolliert zu drehen. Die Steuerung kann auch dazu eingerichtet sein, die Empfangseinrichtung mittels wenigstens eines dritten Linearantriebes zumindest teilweise längs einer Achse kontrolliert zu verfahren. Schließlich kann die Steuerung auch dazu eingerichtet sein mittels eines Linearantriebes einen durch die Empfangseinrichtung geführten Träger längs einer der ersten und/oder zweiten Achsen kontrolliert zu verfahren. Dieser Träger dient dazu, die Bauteile in vereinzelter Form aufzunehmen.

Bei der Bauteilhandhabungsvorrichtung sind in einer Variante die Aufnehmer der ersten und/oder der zweiten Wendeeinrichtung dazu eingerichtet, radial zur Drehachse oder das Drehzentrum der jeweiligen Wendeeinrichtung kontrolliert aus- und eingefahren zu werden, und/ oder zum Empfangen und Abgeben eines zu fördernden Bauteils kontrolliert mit Unterdruck und/oder Überdruck beaufschlagt zu werden, und/ oder um ihre jeweilige radiale Bewegungsachse unbeweglich zu sein, oder um ihre jeweilige radiale Bewegungsachse um einen Drehwinkel kontrolliert gedreht zu werden.

Bei einer Bauteilhandhabungsvorrichtung dieser Art sind in einer Variante den Aufnehmern der ersten und/oder der zweiten Wendeeinrichtung zum radialen Aus-/Einfahren bei der Spendestelle, der Übergabestelle zwischen den ersten und zweiten Wendeeinrichtungen diesen zugeordnete Linearantriebe vorgesehen. Diese Linearantriebe greifen in die entsprechend positionierten Aufnehmer jeweils von außerhalb der jeweiligen Wendeeinrichtungen ein und fahren den jeweiligen Aufnehmer radial aus- und ein. In einer anderen Variante fahren diese Linearantriebe den jeweiligen Aufnehmer lediglich aus, während eine Rückstellfeder den jeweiligen Aufnehmer einfährt. In einer weiteren Variante ist jedem der Aufnehmer ein bidirektionaler oder unidirektionaler Radialantrieb zugeordnet.

In einer Variante der Bauteilhandhabungsvorrichtung stellen Ventile zu jedem der einzelnen Aufnehmer individuell und positionsgerecht eine Zuführung von Unterdruck und Überdruck bereit um frei oder positionsgesteuert die Funktionen: (i) Ansaugen des Bauteils, (ii) Halten des Bauteils, (iii) Ablegen des Bauteils mit oder ohne gesteuertem Abblas-Impuls, und/oder freies Abblasen des Bauteils zu realisieren.

In einer Variante der Bauteilhandhabungsvorrichtung sind der ersten Wendeeinrichtung zwischen der Spendestelle und der Übergabestelle, und/oder der zweiten Wendeeinrichtung zwischen der Übergabestelle und der Ablagestelle jeweils Lage- und Eigenschaftssensoren zugeordnet. Diese Sensoren sind dazu eingerichtet, Lagedaten und/oder Eigenschaften des geförderten Bauteils und/oder Positionsdaten zur Lageregelung der Manipulatoren (Aufnehmer) und der Empfangsstellen zu erfassen und für die Steuerung zur Verfügung zu stellen.

In einer Variante der Bauteilhandhabungsvorrichtung sind wenigstens einige der Lage- und Eigenschaftssensoren dazu eingerichtet, jeweils wenigstens eine Deckfläche und/oder eine oder mehrere Mantelflächen des geförderten Bauteils zu inspizieren um dessen Lagedaten und/oder Eigenschaften zu erfassen und für die Steuerung zur Verfügung zu stellen.

In einer Variante der Bauteilhandhabungsvorrichtung sind im Zentrum der ersten Wendeeinrichtung und/oder im Zentrum der der zweiten Wendeeinrichtung jeweils ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Basierend auf den Eigenschaftsdaten und/oder den Lagedaten des Sensors / dieser Sensoren kann dann eine Korrektur bei Eigenschaftsfehlern und/oder Lagefehlern des zu empfangenden Bauteils bzw. der Empfangsstelle durch die Steuerung erfolgen. Dabei ist/sind der/die bildgebende/n Lagesensor/en dazu eingerichtet, einen Bildeinzug jeweils während der Wendebewegung der ersten bzw. zweiten Wendeeinrichtung zwischen benachbarten Aufnehmern auszuführen und für die Steuerung zur Veranlassung entsprechender Korrekturbewegungen der Ausstoßeinheit, dem Bauteilvorrat oder Wafer, der Wendeeinrichtungen und/oder der Empfangseinrichtung zur Verfügung zu stellen. In einer anderen Variante ist die Ausstoßeinheit feststehend.

Zusätzlich oder alternativ zu diesen bildgebenden Eigenschafts- und/oder Lagesensoren können relativ zu den ersten und zweiten Wendeeinrichtungen extern vorgesehene bildgebende Eigenschafts- und/oder Lagesensoren zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen sein. Basierend auf den Eigenschaftsdaten und/oder den Lagedaten dieses Sensors / dieser Sensoren kann dann eine Korrektur bei Eigenschaftsfehlern und/ oder Lagefehlern des zu empfangenden Bauteils bzw. der Empfangsstelle durch die Steuerung erfolgen. Unabhängig von dem vorstehend beschriebenen Inspektionssystem und funktional als Bestandteil dem Handhabungssystem zuzuordnen, können jeweils im Zentrum der beiden Wendeeinrichtungen eine nach oben gerichtete Bauteilvorrats-Kamera (mit 90°-Spiegelsystem und Beleuchtung) bzw. eine bevorzugt aber nicht zwingend baugleiche nach unten gerichtete Baugruppe als Ablege-Kamera angeordnet sein. Sie dienen zur Positionserfassung der Bauteile bzw. der Empfangsstellen mit dem Ziel der Positionskorrektur bei auftretenden Lagefehlern der Bauteile bzw. der Empfangsstellen. Der Bildeinzug erfolgt jeweils während der Schwenkbewegung der beiden Wendeeinrichtungen durch einen Fensterbereich zwischen den Aufnehmern mit anschließender Wafer - bzw. Empfangseinrichtungs-Korrekturbewegung. Hier sind auch Alternativen mit extern gelagerten Wafer- bzw. Ablege-Kameras möglich.

In einer Variante der Bauteilhandhabungsvorrichtung ist der Übergabestelle und/oder der Ablagestelle eine Ausschleusstelle vor- oder nachgelagert, die dazu eingerichtet ist, durch die Steuerung gesteuert, ein durch die Steuerung mittels wenigstens eines der Lage- und Eigenschaftssensoren als Schlechtteil erkanntes Bauteil auszuschleusen, und es nicht als Gutteil in die Empfangseinrichtung abzulegen.

In einer Variante der Bauteilhandhabungsvorrichtung sind der ersten und/oder der zweiten Wendeeinrichtung jeweils eine ganzzahlige Anzahl von n Aufnehmern zugeordnet. Dabei gilt n >= 2. Die Anzahl der Aufnehmer der ersten Wendeeinrichtung und die Anzahl der Aufnehmer der zweiten Wendeeinrichtung können dabei gleich oder unterschiedlich sein.

In einer Variante der Bauteilhandhabungsvorrichtung schließen die ersten, zweiten und/oder dritten Achsen zueinander jeweils einen Winkel von 90° plus/minus maximal 10° oder 15° ein.

In einer Variante der Bauteilhandhabungsvorrichtung sind die Lage-/Eigenschaftssensoren bildgebende Sensoren mit übereinstimmenden oder voneinander abweichenden Erfassungsspektren, oder berührend oder berührungslos distanzmessende Lagesensoren, oder berührend oder berührungslos erfassende Eigenschaftssensoren.

Die Lage- und Eigenschaftssensoren können bildgebende Sensoren mit geradlinigen oder abknickenden optischen Achsen sein.

Die Kamera-Systeme der Lage- und Eigenschaftssensoren einschließlich ihrer Spiegel- und Beleuchtungseinheiten können durch ihre räumliche Anordnung derart kombiniert sein, dass die Bauteil-Inspektion der jeweils zugewandten Bauteilfläche und zweier seiner Mantelflächen parallelisiert an einer einzigen Prozessposition realisierbar ist. Insgesamt genügen zwei Prozesspositionen zur kompletten Inspektion aller sechs Seitenflächen eines zum Beispiel quaderförmigen Bauteils. Dazu werden an jeder der beiden Prozesspositionen von dem Bauteil drei der sechs Seitenflächen erfasst. Als Inspektionsposition einer jeden Wendeeinrichtung kann in einer Variante dabei die jeweils dritte Prozessposition in etwa horizontal auf Höhe der Rotations- oder Schwenkachse festgelegt sein.

Zusätzliche positionsmessende Aufgaben können zwei weiteren Kamera-Systemen (Vorder-/Rückseiten-Kamera) zugeordnet sein.

In einer Variante der Bauteilhandhabungsvorrichtung sind die ersten und/oder zweiten Wendeeinrichtungen zumindest annähernd stern- oder radförmig ausgestaltet. Die Wendeeinrichtungen können präzisionsgelagert sein und ihre Positionierung längs der jeweiligen Achsen bzw. um die jeweiligen Achsen kann mittels axial angeordnetem linear bzw. rotatorisch wirkendem Antrieb erfolgen, gepaart mit einem hochauflösenden (zum Beispiel rotatorischen oder linearen) Encoder. Die jeweiligen Aufnehmer können am äußeren Umfang verteil angeordnet sein und radial nach außen weisende Saugkontaktstellen für die zu fördernden Bauteile haben.

Ein Vorteil der axial um etwa 90° versetzten Anordnung der Wendeeinrichtungen zueinander besteht darin, dass die Bauteile in ihrer Lage während des Förder-Prozesses bei Übergabe von einer Wendeeinrichtung zur nächsten eine 90°-Drehung um die Aufnehmerachse, relativ zur jeweiligen Bewegungsebene der Aufnehmer (bzw. Wendeeinrichtung-Achse) ausführen, ohne, dass dafür der Aufnehmer selbst rotatorisch verfahrbar gelagert werden muss. Diese Orientierungsänderung der Bauteile ermöglicht wiederum eine wesentliche vereinfachte Inspektion der vier Bauteil-Schnittflächen (=Bauteilseitenflächen). Hierfür dient ein durch je ein, der Bauteil-Schnittfläche zugewandtes, orthogonal zur Aufnehmer-Bewegungsebene (also in axialer Richtung der Wendeeinrichtung) angeordnetes Kamera-System mit vorzugsweise sehr geringem Abstand zu den Bauteil-Schnittflächen (= Mantelflächen des Bauteils) selbst.

Die Erfassung der Fehlpositionierung von Aufnehmer und Bauteil zueinander bzw. zu den Übergabe- und Inspektionspositionen erfolgt unter Nutzung der Kamera- Systeme als Aufnehmer- bzw. Bauteil-Lage-erfassendes Messsystem. Bei sehr hohen Genauigkeitsanforderungen können zusätzlich jeweils drei distanzmessende Sensoren für die Bondtool-Lageerfassung je Wendeeinrichtung zusätzlich vorgesehen sein.

Die optischen Achsen der Kameras "durchdringen" die inspizierte Bauteil-Oberfläche. Sie bilden ein Bezugssystem für die Aufnehmer-Lage. Hiervon abgeleitet lassen sich durch die in einer Ebene parallel zur idealen Aufnehmer-Bewegungsebene der rotierenden Wendeeinrichtung angeordneten distanzmessenden Sensoren Abweichungen der Aufnehmer-Bewegungsbahn von der Soll-Bewegungsbahn ermitteln. Daraus sind die auftretenden Positionsfehler in den Übergabepositionen bestimm- und durch die Steuerung kompensierbar.

Je nach Funktionsprinzip der zusätzlichen Lagesensoren lassen sich die Referenzmessungen zur Aufnehmer-Lage im laufenden Prozess oder auch während zyklisch sich wiederholender Referenzfahrten (zum Beispiel mittels tastend berührender Messsensoren erforderlich) realisieren. Dafür sind sowohl zu Prozessbeginn zur Erfassung räumlicher Lagefehler, als auch während des Prozesses zur Einbeziehung thermisch bedingter Verlagerungen zyklische Referenzfahrten (bei berührenden Sensoren mit kurzzeitiger Prozessunterbrechung) erforderlich, wobei letztere auch relativ lang sein können.

In einer Variante wird zur Kompensation von Positionsfehlern der Wendeeinrichtungen der Aufnehmer insbesondere in den Bauteil-Übergabepositionen und der darauf fixierten Bauteile (in Übergabe und Inspektionspositionen) eine rotatorische Korrekturbewegung des Rotorantriebes und orthogonal eine lineare Korrekturbewegung in Achsrichtung ausgeführt. Hierfür kann in einer Variante die Rotor-Antriebsbaugruppe auf einem Verfahrschlitten angeordnet sein und mittels eines positionsgeregelten Antriebes, zum Beispiel eines Exzenterantriebes um begrenzte Wegsegmente verfahren werden.

In einer Variante der Bauteilhandhabungsvorrichtung erfordert die starre Kopplung mehrerer Aufnehmer an einer Wendeeinrichtung eine Übertragung der Korrekturwerte von einer Bauteil-Übergabe-Position bzw. Inspektionsposition zu den in der Abfolge nächsten Positionen. Diese Korrekturen können an einer fixen Übergabeposition beginnen und bei der letzten Bauteil-Übergabe in die Empfangsstelle enden. Dabei werden die summarischen Lagefehler entlang der bis zu drei Achsen und die Verdrehung um die bis zu drei Achsen durch die Empfangseinrichtung kompensiert.

In einer Variante der Bauteilhandhabungsvorrichtung sind die Aufnehmer an ihrer jeweiligen Wendeeinrichtung nicht drehbar gelagert. So kann ein Orientierungsfehlerausgleich von Bauteilen während des Förderns selbst nicht erfolgen. Daher ist in einer Variante im nachgelagerten Peripheriebereich, insbesondere in der Empfangseinrichtung neben der Achsen-Lagekorrektur auch eine rotatorische Korrekturmöglichkeit vorzusehen.

In einer anderen Variante der Bauteilhandhabungsvorrichtung erfolgt die Rotationskorrektur mit drehbar gelagerten Aufnehmern. Damit kann ein Ausgleichen von Orientierungsfehlern von Bauteilen während des Förderns selbst erfolgen. Der Orientierungsfehler wird dann durch die drehbar gelagerten Aufnehmer der oberen und/oder unteren Wendeeinrichtung korrigiert, bevorzugt durch die Aufnehmer der unteren Wendeeinrichtung.

Die hier vorgestellten Varianten sind im Vergleich zum Stand der Technik kostengünstiger und bieten einen höheren Bauteiledurchsatz, mehr Zeit für Inspektionen und haben weniger bewegte Massen.

Genauer wird eine Lösung für eine Empfangseinrichtung, insbesondere für eine Bauteilhandhabungsvorrichtung der oben vorgestellten Art vorgestellt, bei der eine Empfangseinrichtung für Bauteile dazu eingerichtet ist, relativ zu einer Ablagestelle mittels wenigstens eines Linearantriebes zumindest teilweise längs einer ersten, zweiten und/oder dritte Achsen kontrolliert verstellt zu werden und/oder mittels eines Antriebes einen durch die Empfangseinrichtung geführten Träger längs einer der ersten und/oder zweiten Achsen kontrolliert zu verfahren. Die Empfangseinrichtung weist einen Lagesensor auf, der einer Bauteil-Ablagestelle zugeordnet ist um ein ur teilweise in einer Tasche des Trägers abgelegtes Bauteil in der Bauteil-Ablagestelle zu erfassen, wobei der Lagesensor seitlich zum Träger mit der Empfangseinrichtung derart verbunden ist, dass der Lagesensor Bewegungen der Empfangseinrichtung unmittelbar mit ausführt.

Diese Empfangseinrichtung ist in einer Variante dazu eingerichtet, mittels eines Drehantriebes zumindest teilweise um eine die Ablagestelle enthaltende dritte Achse kontrolliert zu drehen.

Der Sensor kann in einer Variante Bewegungen der Empfangseinrichtung längs der ersten Achse, und/oder längs der zweiten Achse, und/oder um die dritte Achse zusammen mit der Empfangseinrichtung ausführen.

Dazu ist in einer Variante der Sensor mit einem Rahmen der Empfangseinrichtung fest verbunden, in dem der Träger mit den Taschen zur Aufnahme der Bauteile geführt ist. So kann der Sensor einen oberen Rand der Tasche des in dem Rahmen geführten Trägers an der Ablagestelle in Bezug auf die Lage des Bauteils erfassen.

Der Sensor ist in einer Variante als Streifen-Lichtsensor ausgestaltet. Er kann an einer Seite des Rahmens ortsfest angeordnet und dazu eingerichtet sein, ein Lichtband, abgestrahlt aus einer an der gegenüberliegenden Seite des Rahmens angeordneten Streifen-Lichtquelle zu erfassen.

Weiterhin kann der Sensor dazu eingerichtet sein, nachdem dieses Lichtband zumindest annähernd parallel zur Oberseite des Trägers quer zur Förderrichtung des Trägers auf einer der Abmessung der Tasche in Förderrichtung zumindest entsprechenden Länge überstrichen hat, das Lichtband zu erfassen und dieses erfasste Lichtband über seine Länge auszuwerten. Dabei kann das Lichtband durch die Lichtquelle so zu dem oberen Rand der Tasche des in dem Rahmen geführten Trägers an der Ablagestelle ausgerichtet sein, dass es ein nicht vollständig in der Tasche des Trägers abgelegtes Bauteil, das aus der Tasche zumindest teilweise heraus ragt, das Lichtband demzufolge entsprechend zumindest teilweise abschattet. Dazu ist der Sensor dazu eingerichtet, dies an eine Steuerung zu signalisieren.

Der Sensor kann in einer Variante seitlich unterhalb des Trägers an dem Rahmen angeordnet sein, und ein Umlenkspiegel (M) kann dazu vorgesehen sein, das die Oberseite des Trägers überstreichende Lichtband zu dem am Rahmen befestigten Sensor umzulenken. Alternativ oder zusätzlich kann die Lichtquelle seitlich unterhalb des Trägers an dem Rahmen angeordnet sein und ein zweiter Umlenkspiegel kann das Lichtband über den Träger über dessen Oberseite zu dem Umlenkspiegel hin umlenken.

Der Sensor kann als Schwarz-Weiß-Kamera oder als Farb-Kamera ausgestaltet sein.

Auf die Empfangseinrichtung kann ein bildgebender Eigenschafts- und/oder Lagesensor zum Ermitteln von Eigenschaften und/oder der Lage eines zu empfangenden Bauteils in Bezug auf dessen Eigenschaften und/oder seiner Lage zu wenigstens einer der Empfangsstellen vorgesehen sein, mit dem Ziel der Erzeugung von Korrekturanweisungen bei Eigenschafts-und/oder Lagefehlern des zu empfangenden Bauteils bzw. der Empfangsstelle durch die Steuerung zur Veranlassung entsprechender Korrekturbewegungen, und/oder bei der der vierte Drehantrieb dazu eingerichtet ist, durch Steuersignale aus der Steuerung angesteuert, den durch die Empfangseinrichtung geführten Träger längs einer der ersten und/oder zweiten Achsen kontrolliert zu verfahren, und/oder
bei der der dritte Drehantrieb dazu eingerichtet ist, durch Steuersignale aus der Steuerung (ECU) angesteuert, in Abhängigkeit von Signalen aus dem bildgebenden Eigenschafts-und/oder Lagesensor wenigstens eine der Empfangsstellen mit der dort befindlichen Bauteil-Aufnahme des Trägers um die die Ablagestelle enthaltende dritte Achse kontrolliert zu drehen, und/oder
bei der der wenigstens eine Linearantrieb dazu eingerichtet ist, durch Steuersignale aus der Steuerung angesteuert, die Empfangseinrichtung kontrolliert um einen Teil des Rastermaßes benachbarter Bauteil-Aufnahmen des Trägers längs einer der ersten, zweiten und/oder dritten Achsen kontrolliert zu verfahren, und/oder
bei der der Drehantrieb dazu eingerichtet ist, den durch die Empfangseinrichtung geführten Träger entsprechend einem Rastermaß benachbarter Bauteil-Aufnahmen des Trägers längs einer der ersten und/oder zweiten Achsen vorwärts zu fördern.

Eine Absaug- und/oder Ausblaseinrichtung kann der Empfangseinrichtung zugeordnet sein, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen, und/oder
wobei die Empfangseinrichtung Bauteile von einer Wendeeinrichtung empfängt, deren Drehachse im Wesentlichen parallel zur Förderrichtung der Empfangseinrichtung orientiert ist, oder wobei die Empfangseinrichtung Bauteile von einer Wendeeinrichtung empfängt, deren Drehachse im Wesentlichen quer zur Förderrichtung der Empfangseinrichtung orientiert ist.

Auf die Empfangseinrichtung kann ein im Zentrum der Wendeeinrichtung ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils gerichtet sein, und der dazu eingerichtet ist, zwischen am Umfang der Wendeeinrichtung befindlichen benachbarten Aufnehmern hindurch Bildeinzüge wenigstens einer der Ablagestellen oder der Empfangsstellen in der Empfangseinrichtung auszuführen.

Die Empfangseinrichtung kann relativ zu der Ablagestelle mittels eines Linearantriebes zumindest teilweise längs einer ersten Achse kontrolliert in beide Richtungen zu verfahren sein, und/oder mittels eines Drehantriebes kann ein durch die Empfangseinrichtung geführter Träger längs einer der ersten und/oder zweiten Achsen kontrolliert in einer Förderrichtung des Trägers zu verfahren sein. Dabei kann der durch die Empfangseinrichtung geführte Träger mit zwei Empfangsstellen ausgestattet sein, welche zu einer Ablagestelle für Bauteile durch kontrolliertes Betätigen der Antriebe zumindest annähernd fluchtend auszurichten sind, und ein bildgebender Eigenschafts- und/ oder Lagesensor kann Eigenschaften und/oder Lage eines in Bezug auf dessen Eigenschaften und/oder seine Lage zu untersuchendes Bauteil in wenigstens einer der Empfangsstellen in der Empfangseinrichtung liefern, wobei basierend auf Bilddaten aus dem Eigenschafts- und/ oder Lagesensor Korrekturanweisungen bei Eigenschafts- und/oder Lagefehlern des Bauteils durch eine Steuerung zur Veranlassung entsprechender Korrekturbewegungen der Empfangseinrichtung und/oder des in ihr geführten Trägers erfolgen. Außerdem kann der Empfangseinrichtung eine Absaug- und/oder Ausblaseinrichtung zugeordnet sein, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Die hier vorgestellte Lösung erlaubt, die Position und Lage der Wendeeinrichtungen simultan durch Position und/oder Rotation der Empfangseinrichtung zu kompensieren. Deshalb kann der Bauteiledurchsatz der Maschine gegenüber dem Stand der Technik erhöht werden. Um Spiel im Bandantrieb des Ablagebandes zu vermeiden, müssen im Stand der Technik die Antriebe relativ zueinander eingestellt werden. Die hier vorgestellte Lösung vermeidet dies, da der Transport immer nur in eine Richtung erfolgt. Dies ist insbesondere in Anwendungen hilfreich, bei denen die Taschen des Trägerbandes mit einem klebenden Abdeckband nach und nach verschlossen werden. Würde man das Trägerband wieder zurücktransportieren, ergäben sich evtl. Probleme, wenn das Abdeckband wieder abzulösen wäre. Das Spiel im Antrieb kann dabei vernachlässigt werden.

In einer anderen Variante kann auch in die entgegengesetzte Richtung transportiert werden.

Die Korrektur der Position des Bauteils erfolgt an der Empfangseinrichtung. So steht mehr Zeit dafür zur Verfügung. Ein Rück-Transport des Bandes, in dem die Bauteile abgelegt werden, ist nicht mehr erforderlich. Damit kann die Empfangseinrichtung einfacher aufgebaut sein. Ein zweites Antriebsrad für den Rücktransport des Bandes wie beim Stand der Technik ist nicht mehr erforderlich. Vielmehr wird in den erforderlichen Situationen die gesamte Empfangseinrichtung entgegen der Transportrichtung des Ablagebandes bewegt. Der Vorteil ist, dass eine höhere Positioniergenauigkeit des Bandes gegenüber vorbekannten Varianten erreicht wird, in denen die Positionierung ausschließlich über den Transport des Transportbandes bewerkstelligt wird. Auch das nachfolgende Anbringen eines (selbstklebenden) Abdeckbandes (Cover-Tape) auf dem Transportband kann hierbei leichter erfolgen.

In einer Variante ist die Empfangseinrichtung oberhalb einer ortsfesten Grundplatte angeordnet, die Motoren der drei Antriebe sind unterhalb der Grundplatte angeordnet. Die Position der Empfangseinrichtung kann in X, Y und um die Z-Achse rotierend justiert werden. Jede Bewegungsrichtung der Empfangseinrichtung verfügt über einen eigenen Antrieb. Die Position der einzelnen Antriebe ist nicht festgelegt. Die Drehachse für die Z-Korrektur liegt nahe bei der Bauteil-Ablageposition oder fällt in deren Zentrum.

In einer Variante der Empfangseinrichtung ist diese mit zwei Empfangsstellen ausgestattet, welche zu der Ablagestelle durch kontrolliertes Betätigen des Drehantriebes des/der Linearantriebe zumindest annähernd fluchtend auszurichten sind. Die zwei Empfangsstellen sind einem Rastermaß benachbarter Bauteil-Aufnahmen des Trägers entsprechend zueinander zu positionieren.

In einer Variante der Empfangseinrichtung ist ein bildgebender Eigenschafts- und/ oder Lagesensor zum Ermitteln von Eigenschaften und/oder der Lage eines zu empfangenden Bauteils in Bezug auf dessen Eigenschaften und/oder seiner Lage zu wenigstens einer der Empfangsstellen in der Empfangseinrichtung vorgesehen. Dieser bildgebende Eigenschafts- und/ oder Lagesensor befindet sich im oder beim Zentrum der unteren Wendeeinrichtung. Mit den Bilddaten aus diesem Sensor kann die Erzeugung von Korrekturanweisungen bei Eigenschafts- und/oder Lagefehlern des zu empfangenden Bauteils bzw. der Empfangsstelle durch die Steuerung zur Veranlassung entsprechender Korrekturbewegungen erfolgen.

In einer anderen Variante sind zwei weitere bildgebende Eigenschafts- und/ oder Lagesensoren bei der Empfangseinrichtung vorgesehen. Der eine Sensor ist von oben auf das zweite Fenster gerichtet um Qualitätsfehler zu untersuchen. Der andere Sensor ist beim ersten Fenster seitlich angeordnet um ein Verkippen des Bauteils besser gegenüber dem oben erläuterten Sensor detektieren zu können.

In einer Variante der Empfangseinrichtung ist der vierte Drehantrieb dazu eingerichtet, durch Steuersignale aus der Steuerung angesteuert, mittels einer mechanischen Traktion den durch die Empfangseinrichtung geführten Träger längs einer der ersten und/oder zweiten Achsen kontrolliert um etwa 80 - 120%, vorzugsweise etwa 100% plus minus maximal 3%, des Rastermaßes benachbarter Bauteil-Aufnahmen des Trägers zu verfahren. Dabei kann auch der Drehantrieb dazu eingerichtet sein, durch Steuersignale aus der Steuerung angesteuert, in Abhängigkeit von Signalen aus dem bildgebenden Eigenschafts- und/oder Lagesensor wenigstens eine der Empfangsstellen mit der dort befindlichen Bauteil-Aufnahme des Trägers um die die Ablagestelle enthaltende dritte Achse kontrolliert um bis zu plus minus 6 °, vorzugsweise um bis zu plus minus 3 ° zu drehen. Des Weiteren kann ergänzend oder alternativ der wenigstens eine Linearantrieb dazu eingerichtet sein, durch Steuersignale aus der Steuerung angesteuert, die Empfangseinrichtung kontrolliert um etwa plus minus maximal 20%, vorzugsweise um bis zu plus minus 3% des Rastermaßes benachbarter Bauteil-Aufnahmen des Trägers längs einer der ersten, zweiten und/oder dritten Achsen kontrolliert zu verfahren.

In einer Variante der Empfangseinrichtung ist der vierte Drehantrieb dazu eingerichtet, den durch die Empfangseinrichtung geführten Träger entsprechend einem Rastermaß benachbarter Bauteil-Aufnahmen des Trägers längs einer der ersten und/oder zweiten Achsen vorwärts zu fördern.

In einer Variante der Empfangseinrichtung ist eine Absaug- und/oder Ausblaseinrichtung vorgesehen, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Im Betrieb einer Variante der Empfangseinrichtung greift ein durch den vierten Drehantrieb angetriebenes Stachelrad in Transportlöcher des Ablagebandes für dessen Transport in Förderrichtung ein. Das Stachelrad dreht dabei bevorzugt nur in eine Vorwärts-Richtung. Das Ablageband hat in regelmäßigen Abständen Ablagetaschen für die Bauteile. Pro Ablagetasche dreht das Stachelrad um einen festen Winkelbetrag (z.B. 30°, 60°, 90°, 180° ..., 360°). Aus der Bildaufnahme durch die Kamera im Zentrum der zweiten Wendeeinrichtung ist die Lage der Ablagetasche bekannt, in welche das Bauteil abgelegt wurde. Durch die Kamera am Außenumfang der zweiten Wendeeinrichtung ist überdies bekannt, ob das nächste abzulegende Bauteil am Aufnehmer verdreht gehalten wird. Aus diesen Lageinformationen wird in der Steuerung errechnet, um welche Strecken- und/oder Winkel-Beträge die Empfangseinrichtung umpositioniert werden muss. Außerdem wird bei der Positionierung der Empfangseinrichtung auch berücksichtigt, dass sich die Wendeeinrichtung in x- und y- Richtung entsprechend bewegen wird, um das Bauteil an der Übergabeposition von der oberen zur unteren Wendeeinrichtung korrekt zu übernehmen. Die Empfangseinrichtung wird dann, soweit notwendig, entlang der (X-, Y-)Achsen linear verfahren und ggf. rotiert um die Feinjustierung der Ablage des Bauteils sicherzustellen.

Wenn ein Bauteil in der Ablageposition abgelegt wurde, hat die Kamera im Zentrum der darüber angeordneten zweiten Wendeeinrichtung auch erfasst, ob das Bauteil fehlerhaft ist, d.h. ob es durch das Ablegen beschädigt wurde oder schon vorher einen Defekt hatte. Sofern bereits vorher ein Bauteil als defekt erkannte wurde, wird es nicht abgelegt.

Die Ablageposition in der Empfangseinrichtung kann gleichzeitig auch eine erste Absaugposition sein. Dazu ist an der Empfangseinrichtung ein Absauger mit Unterdruck an der Ablageposition angeordnet. In Förderrichtung des Trägerbandes gibt es eine zweite alternative Absaugposition. Das heißt, an der Empfangseinrichtung sind zwei Fenster vorgesehen: ein erstes Fenster mit einer Ablageposition und ein zweites Fenster mit einer Absaugposition. Der Abstand zwischen beiden Fenstern entspricht dem Rastermaß des Trägerbandes und ist auf das Rastermaß einstellbar. Wurde das Bauteil nicht korrekt abgelegt, so dass es schräg darin liegt, oder noch teilweise herausragt, wird dies durch eine Kamera im Zentrum der zweiten Wendeeinrichtung erkannt. Das Trägerband kann aufgrund des nicht korrekt abgelegten Bauteils nicht weitertransportiert werden. Deshalb wird das Bauteil an der Ablageposition abgesaugt und durch das nächste abzulegende Bauteil ersetzt. Ist das Bauteil beschädigt, kann es an dieser Position ebenfalls entfernt und durch das nächste abzulegende Bauteil ersetzt werden. An der Position des zweiten Fensters kann - ggf. mit einer weiteren Kamera - auf Fehler inspiziert werden. Bei einem als defekt erkanntem Bauteil wird die Empfangseinrichtung insgesamt zurückbewegt und an das als defekt erkannte Bauteil an der Ablageposition abgesaugt.

Alternativ kann die zweite Absaugposition verwendet werden, um das als defekt erkannte Bauteil zu entfernen.

Mit der hier vorgestellten Anordnung ist es möglich, ein Bauteil zur Erkennung von Fehlern zu inspizieren. Das Bauteil ist mit der ersten und zweiten Wendeeinrichtung abzulegen, und ein als defekt erkanntes Bauteil an der Ablageposition zu entfernen. Dies erfolgt an einer gemeinsamen Position.

Die Empfangseinrichtung bewegt sich in drei Richtungen: In X-, und Y-Richtung, und um ihre (Z-)Hochachse im / nahe dem Zentrum der Ablageposition. Dies ist auch im Unterschied zu herkömmlichen Anordnungen zu sehen, bei denen das Trägerband in Transportrichtung gefördert wird und die Empfangseinrichtung senkrecht zur Bandtransportrichtung für die Positionierung zur Bauteilablage bewegt wird. Die Ablegestelle kann auch in Gestalt einer Schale (eines Trays, z.B. Jedec-Tray,) oder als Antennenbahn vorliegen.

In einer alternativen Variante ist der Empfangseinrichtung eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Die Empfangseinrichtung kann in einer Variante Bauteile von einer Wendeeinrichtung empfangen, deren Drehachse im Wesentlichen parallel zur Förderrichtung der Empfangseinrichtung orientiert ist, oder die Empfangseinrichtung kann in einer weiteren Variante Bauteile von einer Wendeeinrichtung empfangen, deren Drehachse im Wesentlichen quer zur Förderrichtung der Empfangseinrichtung orientiert ist.

Im Zentrum der Wendeeinrichtung ist in einer Variante ein bildgebender Eigenschafts- und/oder Lagesensor zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen. Dieser bildgebende Eigenschafts- und/oder Lagesensor ist dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

In einer alternativen Variante ist im Zentrum der Wendeeinrichtung ein Umlenkspiegel oder Prisma angeordnet, der dem außerhalb der Wendeeinrichtung angeordneten bildgebenden Eigenschafts- und/oder Lagesensor zugeordnet ist, zum Ermitteln von Eigenschaften und/ oder der Lage eines zu empfangenen Bauteils bzw. zum Ermitteln der Lage von Empfangsstellen in der Empfangseinrichtung und/oder darin befindlichen Bauteils. Der Umlenkspiegel oder das Prisma zusammen mit dem außerhalb der Wendeeinrichtung angeordneten bildgebenden Eigenschafts- und/oder Lagesensor sind dazu eingerichtet, zwischen am Umfang der Wendeeinrichtung befindlichen benachbarten Aufnehmern hindurch Bildeinzüge wenigstens einer der Empfangsstellen in der Empfangseinrichtung auszuführen.

Die Empfangseinrichtung ist relativ zu einer Ablagestelle mittels eines Linearantriebes zumindest teilweise längs einer ersten Achse kontrolliert in beide Richtungen zu verfahren. Mittels eines Drehantriebes ist ein durch die Empfangseinrichtung geführter Träger längs einer der ersten und/oder zweiten Achsen kontrolliert in einer Förderrichtung des Trägers zu verfahren. Der durch die Empfangseinrichtung geführte Träger ist mit zwei Empfangsstellen ausgestattet, welche zu einer Ablagestelle für Bauteile durch kontrolliertes Betätigen der Antriebe zumindest annähernd fluchtend auszurichten sind. Ein bildgebender Eigenschafts- und/ oder Lagesensor liefert Eigenschaften und/oder Lage eines in Bezug auf dessen Eigenschaften und/oder seine Lage zu untersuchendes Bauteil in wenigstens einer der Empfangsstellen in der Empfangseinrichtung. Basierend auf Bilddaten aus dem Eigenschafts- und/ oder Lagesensor erfolgen Korrekturanweisungen bei Eigenschafts- und/oder Lagefehlern des Bauteils durch eine Steuerung zur Veranlassung entsprechender Korrekturbewegungen der Empfangseinrichtung und/oder des in ihr geführten Trägers. Der Empfangseinrichtung ist eine Absaug- und/oder Ausblaseinrichtung zugeordnet, um aus wenigstens einer der Empfangsstellen in der Empfangseinrichtung und/oder dem in der Empfangseinrichtung geführten Träger ein als schadhaft und/oder fehlerhaft platziert erkanntes Bauteil zu entfernen.

Ein Verfahren zum Entnehmen fehlerhafter Bauteile aus einer Empfangseinrichtung insbesondere der vorstehend beschriebenen Bau-/Funktionweise weist folgende Schritte auf: Erfassen eines nicht korrekt abgelegten Bauteils in einer Tasche des Trägers für ein Bauteil an der ersten Empfangsstelle,
Bewegen der Empfangseinrichtung mittels eines Linearantriebes längs der Förderrichtung, so dass das nicht korrekt abgelegte Bauteil sich an der zweiten Empfangsstelle befindet, ohne dabei den in der Empfangseinrichtung geführten Träger zu fördern,
Absaugen des nicht korrekt abgelegten Bauteils an der zweiten Empfangsstelle aus der Tasche für ein Bauteil;
Zurückbewegen der Empfangseinrichtung mittels des Linearantriebes entgegen der Förderrichtung, so dass das eine leere Tasche für ein Bauteil sich an der ersten Empfangsstelle befindet, ohne dabei den in der Empfangseinrichtung geführten Träger zu fördern, Ablegen eines Bauteils in der Tasche des Trägers an der ersten Empfangsstelle.

Aufgrund gestiegener Qualitätsanforderungen bei gleichzeitig sinkenden Abmessungen elektronischer Bauteile, die überdies in stets sinkenden Prozesszeiten zu verarbeiten sind, wurden die herkömmlichen Sensoranordnungen als nicht ausreichend erkannt.

Als eine Variante wird daher ein bildgebender Sensor vorgeschlagen, der geeignet und bestimmt ist zur Erfassung von Lage- und/oder Eigenschaften eines Bauteils, insbesondere in einer Bauteilhandhabungsvorrichtung der vorstehend offenbarten Art. Dieser bildgebende Sensor ist mit wenigstens zwei voneinander abweichenden Erfassungsspektren ausgestattet. Er ist insbesondere geeignet und bestimmt zur Erfassung von Eigenschaftsfehlern und/oder Lagefehlern eines in der Empfangsstelle einer Empfangseinrichtung befindlichen Bauteils. Dieser bildgebende Sensor ist geeignet und bestimmt, mit Strahlungsquellen zusammenzuwirken, die hinsichtlich Strahlungsspektrum und Strahlungsauftreffwinkel und/oder Strahlungsreflexionswinkel relativ zu dem bildgebenden Sensor auf diesen abgestimmt sind. Der bildgebende Sensor ist geeignet und dazu eingerichtet, für jedes seiner Erfassungsspektren einer ihm nachgeordneten Bildauswertung einen separaten Bildeinzug bereitzustellen.

Bei diesem bildgebenden Sensor sind beispielsweise die wenigstens zwei voneinander abweichenden Erfassungsspektren im sichtbaren und nicht sichtbaren Bereich ausgestaltet. Sie können auch als roter Farbbereich - 630nm plus minus 30 nm -, und/ oder grüner Farbbereich - 530 nm plus minus 60 nm -, und/oder blauer Farbbereich - 460nm plus minus 50 nm - eines Farbsensors ausgestaltet sein.

In einer Variante des bildgebenden Sensors sind optisch wirksame Elemente vorgesehen, die dazu eingerichtet sind, den Sensor mit einem Bauteil in wenigstens einer der Empfangsstellen in der Empfangseinrichtung und/oder dem in der Empfangseinrichtung geführten Träger optisch zu koppeln.

In einer Variante des bildgebenden Sensors umfassen die optisch wirksamen Elemente Umlenkspiegel, Prismen, Farbfilter und/oder Linsen.

Einzelne der optisch wirksamen Elemente und/oder der Strahlungsquellen können dazu eingerichtet sein, unabhängig von anderen aktiviert, ausgerichtet und/oder justiert / fokussiert zu werden.

Die hier offenbarte integrierte Handhabungs-/Inspektionseinrichtung verwendet bildgebende Sensoren, die einerseits alle oder fast alle Deck- und/oder Seitenfläche(n) eines Bauteils inspizieren und dabei andererseits auch relevante Daten zur Positionierung der Manipulatoren (Aufnehmer) an der ersten und/oder der zweiten Wendeeinrichtung und der Empfangsstellen liefern.

Der bildgebende Sensor der ersten (oberen) Wendeeinrichtung ist in einer Variante eine Farbkamera im Zentrum der Wendeeinrichtung. Alternativ kann die Kamera auch eine Schwarz/Weiß-Kamera sein, die in einer weiteren Variante seitlich und mit einem 45° - Umlenkspiegel im Zentrum der Wendeeinrichtung zusammenwirkt. Diese Kamera erfasst während der Rotation der oberen Wendeeinrichtung durch den Spalt zwischen zwei Aufnehmern das im nächsten Schritt von dem Bauteil-Ausstoßer aus dem Bauteilvorrat vereinzelte Bauteil. Aus dem dabei gewonnenen Bildeinzug ist sowohl eine Inspektion des Bauteils als dessen exakte Positionsbestimmung im Bauteilvorrat möglich. Der Bildeinzug findet während der Rotation der oberen Wendeeinrichtung, in dem als Blickfenster bezeichneten Zeitraum statt.

Die hier offenbarte integrierte Handhabungs-/Inspektionseinrichtung verwendet außerdem bildgebende Sensoren in Form von seitlichen Kameras an der oberen Wendeeinrichtung. Diese sind etwa bei 90° radial außerhalb der oberen Wendeeinrichtung derart angeordnet, dass das Bauteil auf seinem Flugkreis von einer mittleren Kamera frontal erfasst wird und von den zu beiden Seiten der mittleren Kamera jeweils einander gegenüberliegende Mantelfläche erfasst werden. Diese Kameras sind nicht zwingend Farbkameras. Es können mehrere Bildeinzüge angefertigt werden, weil die obere Wendeeinrichtung kurzzeitig (10ms bis 60 ms, zum Beispiel 40 ms) jeweils wegen der nachfolgenden Bauteilübergabe in der 180° Position still steht. Dieser kurze Stillstandszeitraum ist ausreichend für die Inspektion. Dazu können auch Schwarz/Weiß-Kameras eingesetzt sein. Mit der Seiteninspektion durch die beiden seitlichen Kameras werden die Stirnseiten des Bauteils auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Bei den hier verwendeten Kameras kann es sich ebenfalls um Farbkameras handeln. Dies ist jedoch nicht zwingend erforderlich, da wie oben bereits erwähnt aufgrund des Stillstandszeitraums ausreichend Zeit zur Verfügung steht.

Die hier offenbarte integrierte Handhabungs-/Inspektionseinrichtung verwendet außerdem bildgebende Sensoren in Form von seitlichen Kameras an der unteren Wendeeinrichtung. Diese sind etwa bei 90° radial außerhalb der unteren Wendeeinrichtung derart angeordnet, dass das Bauteil auf seinem Flugkreis von einer mittleren Kamera frontal erfasst wird und von den zu beiden Seiten der mittleren Kamera befindlichen Kameras jeweils einander gegenüberliegende Mantelflächen erfasst werden. Diese Kameras sind nicht zwingend Farbkameras. Vielmehr können auch Schwarz/Weiß-Kameras eingesetzt sein. An dieser Position wird das Bauteil sowohl auf Fehler hin untersucht, als auch werden die Bilddaten auf Positionsdaten hin ausgewertet. Mit der Seiteninspektion durch die beiden seitlichen Kameras wird das Bauteil an seinen Schnittflächen auf Beschädigungen untersucht. Mit der Rückseiteninspektion durch die mittlere Kamera wird die Bauteilrückseite auf Beschädigungen untersucht. Für die Rückseiteninspektion können mehrere Bildeinzüge durchgeführt werden um verschiedene Defekte hervorzuheben. Für die nachfolgende Ablage des Bauteils in der Empfangseinrichtung können die Positionsdaten (x, y, Verdrehung) des Bauteils mit der Seiteninspektion ermittelt werden. In einer anderen Variante wird hierfür die Rückseiteninspektion verwendet. Diese Informationen werden von der Steuerung verwendet um etwaige Korrekturen durchzuführen. Bei den hier verwendeten Kameras kann es sich ebenfalls um Farbkameras handeln. Dies ist jedoch nicht zwingend erforderlich, da während des Stillstandszeitraums ausreichend Zeit zur Verfügung steht.

Die hier offenbarte integrierte Handhabungs-/Inspektionseinrichtung verwendet des Weiteren bildgebende Sensoren in Form einer Kamera im Zentrum der unteren Wendeeinrichtung. Diese Kamera kann eine Farbkamera mit drei einzelnen Kanälen R, G, B sein. Dabei ist es unerheblich, ob eine 3-Chip Farbkamera oder eine 1-Chip Farbkamera eingesetzt wird. 3-Chip Kameras haben für jede Farbe R, G, B einen separaten Bildsensor, eine 1-Chip Kamera verwendet alternierend aktivierte Filter vor dem Bildsensor. Eine hier einsetzbare Schwarz/Weiß-Kamera hat einen Kanal mit zum Beispiel 255 Grau-Stufen, bei einer Farbkamera hat jeder der drei Kanäle zum Beispiel 255 Intensitäts-Stufen einer Farbe. Wesentlich ist, dass die drei Farbkanäle der Kamera getrennt voneinander ansprechbar/auszulesen sind, oder zumindest eine Aufspaltung der drei Farbkanäle in der Steuerung erfolgen kann. Für jeden Kanal sind unterschiedliche Belichtungszeiten möglich. Hier können zum Beispiel folgende Belichtungszeiten verwendet werden: 5 ms (grün), 12 ms (rot), 15 ms (blau). Entsprechend der jeweils aktivierten Farbkanäle werden bei der hier offenbarten integrierte Handhabungs-/Inspektionseinrichtung auch unterschiedliche Beleuchtungsfarben verwendet. Weißes Licht ist zwar eine Mischung aus allen Farben, so dass mit dieser Beleuchtungsfarbe alle Kanäle gleichzeitig angesprochen werden könnten. Dies findet hier jedoch dezidiert nicht statt, wenn die erzielbare Bildqualität den Anforderungen nicht entspricht.

Dem bildgebenden Sensor ist in einer Variante ein halbdurchlässiger Spiegel zugeordnet, der unter einem Winkel von etwa 45° zur optischen Achse des Kamera-Chips angeordnet ist und dazu dient, farbiges Licht zweier, mehrerer oder beliebig vieler unterschiedlicher Erfassungsspektren aus entsprechenden Lichtquellen optisch einzukoppeln und auf einen Inspektionsbereich zu richten. Dieses auf den Inspektionsbereich, also die Bauteil-Deckfläche oder Seitenfläche und ggf. deren Umgebung in der Tasche, gerichtete Licht wird dort reflektiert und wird von wenigstens einem Kamera-Chip des bildgebenden Sensors erfasst.

Weiterhin ist in einer Variante dem bildgebenden Sensor eine Lichtquelle als Ringlichtquelle um die Inspektionsstelle zugeordnet. Diese Ringlichtquelle liefert Streulicht unter einem Winkel von etwa 5° - 45° in einem dritten Farbbereich. Auch dieses auf den Inspektionsbereich gerichtete Licht wird dort reflektiert und wird von wenigstens einem Kamera-Chip des bildgebenden Sensors erfasst. Das Licht bzw. die verschiedenfarbigen Lichtquellen können beliebig angeordnet sein bzw. auch den gleichen Strahlungswinkel haben.

Die hier offenbarte integrierte Handhabungs-/Inspektionseinrichtung verwendet im Zentrum der unteren Wendeeinrichtung einen Umlenkspiegel zur Einkopplung einer koaxialen Beleuchtung der Empfangseinrichtung. Genauer wird der durch die Empfangseinrichtung geführte Träger in Form eines Ablagebandes mit Ablagetaschen für die Bauteile mit der Kamera erfasst. Durch eine einzige Bildaufnahme erfolgt eine Inspektion auf Fehler, zum Beispiel das schräge Ablegen des Bauteils, so dass es nicht korrekt in seiner Ablagetasche positioniert ist, oder auf Qualitätsmängel. Außerdem werden durch diese einzige Bildaufnahme die Positionsdaten der Ablagetasche des Ablagebandes für das Ablegen des nächsten Bauteils erfasst. Die aus den einzelnen Farbkanälen zu gewinnende Information kann nach zu untersuchenden Aufgabenstellungen beliebig aufgeteilt werden, beispielsweise wie folgt: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Das Bauteil wird bei einer Variante der integrierten Handhabungs-/Inspektionseinrichtung "blind" abgelegt. Das heißt, dass der eigentliche Ablegevorgang auf Informationen oder Positionsdaten basiert, die vor dem Ablegevorgang aus der Bildaufnahme gewonnen wurde, die dem vorherigen Bauteil zugeordnet ist. Im Moment des Ablegevorgangs sieht die Kamera im Zentrum der zweiten Wendeeinrichtung die Ablegestelle nicht, da der momentan ablegende Aufnehmer die Sicht versperrt.

Informationen oder Positionsdaten, ob ein Bauteil verdreht ist, liefert in einer Variante eine Kamera am Außenumfang der unteren Wendeeinrichtung. Die Informationen oder Positionsdaten werden an die Steuerung der Empfangseinrichtung weitergegeben. Aus der Bildaufnahme des zuvor in der Ablagetasche des Ablagebandes abgelegten Bauteils ist die Position der Empfangseinrichtung bekannt. Der Abstand zwischen den beiden Taschen ist ebenso bekannt. Hieraus kann für das nächste abzulegende Bauteil errechnet werden, um welchen Winkel und x- und y-Betrag die Empfangseinrichtung bewegt werden muss.

Aus den weiteren Vorrichtungsaspekten ergeben sich entsprechende ergänzende oder alternative Verfahrensschritte.

Die hier vorgestellte Anordnung bildgebender Sensorik ist in der Lage, mit weniger Bildeinzügen als herkömmliche Sensoranordnungen auszukommen. Die gewonnenen Bilddaten lassen sich sowohl zur Schlechtteilausschleusung als auch zur Positionierung der Aktoren der Handhabungs-/Inspektionseinrichtung auswerten. Diese integrierte Architektur und die sich damit ermöglichende Vorgehensweise reduziert die Prozesszeit und bietet bei erhöhter Durchsatzzahl eine gesteigerte Inspektionsqualität.

### Kurzbeschreibung der Figuren

Weitere Merkmale, Eigenschaften, Vorteile und mögliche Abwandlungen werden für einen Fachmann anhand der nachstehenden Beschreibung deutlich, in der auf die beigefügten Zeichnungen Bezug genommen ist. Dabei zeigen die Fig. schematisch eine optische Untersuchungseinrichtung für ein Bauteil,
Fig. 1 zeigt schematisch eine Bauteilhandhabungsvorrichtung zum Entnehmen von prismatischen oder zylindrischen Bauteilen von einem strukturierten Bauteilvorrat und zum Ablegen an einer Empfangseinrichtung in einer Seitenansicht.
Fig. 2 zeigt schematisch die Ausrichtung der diversen Lage- und Eigenschaftssensoren der Bauteilhandhabungsvorrichtung aus Fig. 1 in Bezug auf die Seitenflächen eines Bauteils.
Fig. 3 zeigt schematisch einen der am Umfang einer oder beider Wendeeinrichtungen der Bauteilhandhabungsvorrichtung angeordneten Lage- und Eigenschaftssensoren in einer Draufsicht.
Fig. 4 zeigt schematisch eine erste Variante einer Empfangseinrichtung zum Einsatz mit der Bauteilhandhabungsvorrichtung in einer perspektivischen Ansicht.
Fig. 5 zeigt schematisch einen der Lage- und Eigenschaftssensoren mit zugeordneter Beleuchtungsanordnung zum Einsatz mit der Bauteilhandhabungsvorrichtung.
Fig. 6 zeigt schematisch eine zweite Variante einer Empfangseinrichtung zum Einsatz mit der Bauteilhandhabungsvorrichtung in einer perspektivischen Ansicht.

### Detaillierte Beschreibung der Figuren

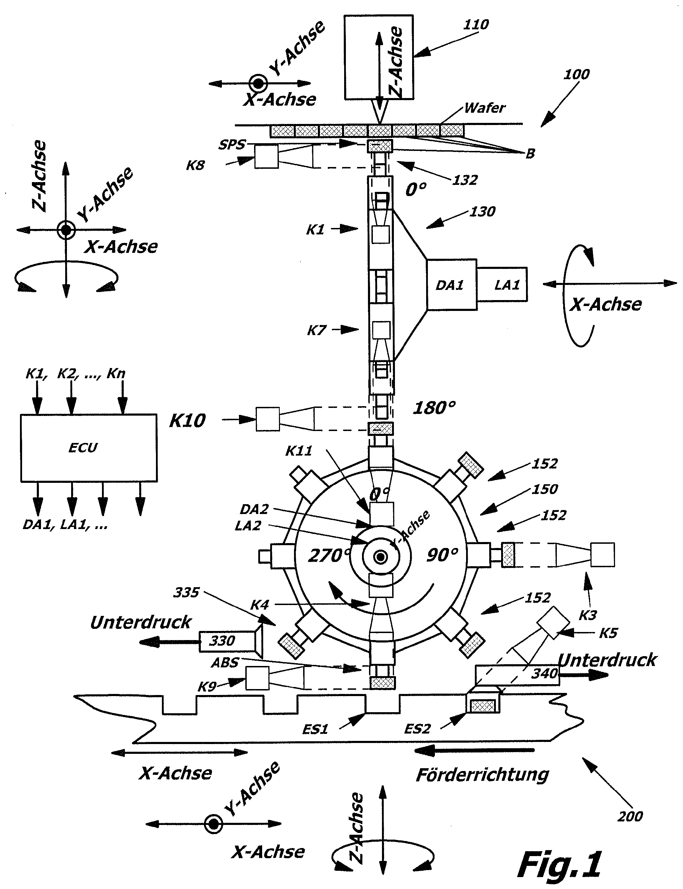

In Fig. 1 ist eine Bauteilhandhabungsvorrichtung 100 zum Entnehmen von prismatischen Bauteilen B in Form elektronischer Halbleiterchips von einem strukturierten Bauteilvorrat und zum Ablegen an einer Empfangseinrichtung 200 veranschaulicht. Die hier vorgestellte Bauteilhandhabungsvorrichtung 100 übernimmt die Bauteile B von einem horizontal im oberen Bereich der Bauteilhandhabungsvorrichtung angeordneten Bauteilvorrat, hier einer Waferscheibe, mit einer ortsfesten Ausstoßeinheit 110.

Die Ausstoßeinheit 110 arbeitet in der gezeigten Variante mit einer durch eine Steuerung ECU kontrollierten Nadel oder sie arbeitet zum Beispiel berührungslos mit einem Laserstrahl, um die Bauteile einzeln von dem Bauteilvorrat freizugeben, damit sie einer ersten Wendeeinrichtung 130 zugeführt werden. Diese erste Wendeeinrichtung 130 hat die Form eines Sterns oder Rades und hat an ihrem Umfang mehrere (im gezeigten Beispiel acht) Aufnehmer 132 für die vereinzelten Bauteile B. Jeder der Aufnehmer 132 ist dazu eingerichtet, wenn er sich bei der 0°-Position der ersten Wendeeinrichtung 130 der Ausstoßeinheit 110 am nächsten befindet, an einer Spendestelle SPS ein Bauteil von dem strukturierten Bauteilvorrat zu empfangen.

Die Aufnehmer 132 sind radial nach außen weisend am (gedachten) Umfang der stern- oder radförmigen ersten Wendeeinrichtung 130 angeordnet und tragen die Bauteile B. Die Aufnehmer 132 der ersten Wendeeinrichtung 130 sind zur Drehachse (hier der X-Achse) radial verfahrbar. Somit können diese Aufnehmer 132 die Bauteile B, jeweils an einem der Aufnehmer 132 fixiert, innerhalb eines Schwenkwinkels - hier zwischen 0° und 180° - zwischen Bauteil-Übernahme und -Übergabe fördern.

Die erste Wendeeinrichtung 130 rotiert das Bauteil B, gesteuert von der nicht weiter veranschaulichten Steuerung ECU um eine erste Achse, hier die X-Achse, zu einer ersten Übergabestelle ÜS um einen ersten vorbestimmten Winkel, hier 180°. Dabei wird das Bauteil B um seine Längs- oder Querachse gewendet. Eine der ersten Wendeeinrichtung 130 ähnliche zweite Wendeeinrichtung 150 mit mehreren, hier ebenfalls acht, zweiten Aufnehmern 152 ist dazu eingerichtet, das Bauteil B an der Übergabestelle ÜS von einem Aufnehmer 132 der ersten Wendeeinrichtung 130 zu empfangen, wenn das Bauteil sich bei der 0°-Position der zweiten Wendeeinrichtung 130 der Übergabestelle ÜS am nächsten befindet.

Die zweite Wendeeinrichtung 150 wendet das empfangene Bauteil B, gesteuert von der Steuerung ECU, um eine zweite Achse, hier die Y-Achse, um einen zweiten vorbestimmten Winkel, hier um etwa 180°, um seine Längs- oder Querachse und fördert es zu einer Ablagestelle ABS.

Die ersten, zweiten und/oder dritten Achsen schließen miteinander jeweils einen Winkel von 90° plus/minus maximal 10° oder 15° ein und orientieren sich an einem dreidimensionalen orthogonalen Koordinatensystem.

Die beiden stern- oder radförmigen Wendeeinrichtungen 130, 150 sind orthogonal zueinander angeordnet und stimmen ansonsten in ihrem Aufbau überein. Abweichend von der Darstellung in Fig. 1 kann die Anordnung der beiden Wendeeinrichtungen 130, 150 relativ zur Förderrichtung der Empfangseinrichtung 200 auch um die Z-Achse um 90° gedreht sein. In diesem Fall ist die untere Wendeeinrichtung 150 zumindest annähernd quer zur Förderrichtung der Empfangseinrichtung 200 orientiert.

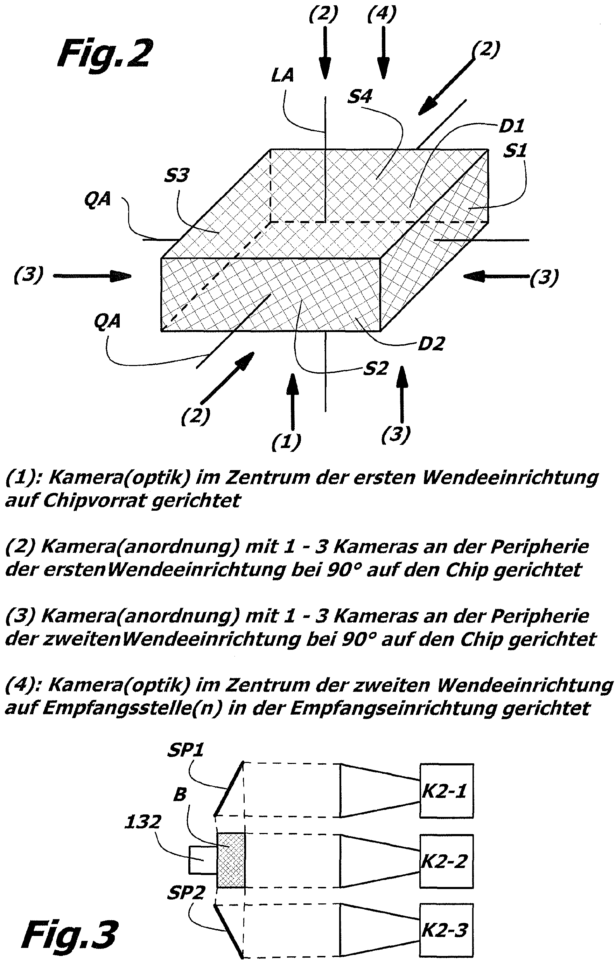

Den ersten und zweiten Wendeeinrichtungen 130, 150 sind Lage- und Eigenschaftssensoren K1 ... K4 zugeordnet. Wie in Fig. 1 gezeigt, befinden sich diese Sensoren an mehreren Stellen der Gesamtanordnung. Sie sind dazu eingerichtet, Lagedaten der ersten und zweiten Wendeeinrichtungen 130, 150, Lagedaten von an den Aufnehmern 132, 152 befindlichen Bauteilen B, sowie Eigenschaften von an den Aufnehmern 132, 152 befindlichen Bauteilen B zu erfassen. Die dabei gewonnenen Daten werden einer Steuerung zur Verfügung gestellt. In der hier veranschaulichten Ausführung ist eine erste Kameraanordnung K1 im Zentrum der ersten Wendeeinrichtung 130 senkrecht nach oben auf den Bauteilvorrat gerichtet. Eine zweite Kameraanordnung K2 mit drei Kameras - in Fig. 1 nicht zu sehen - ist an der Peripherie der ersten Wendeeinrichtung 130 bei 90° auf das daran vorbeigeführte Bauteil B gerichtet. Details zu dieser zweiten Kameraanordnung K2 werden im Zusammenhang mit Fig. 3 erläutert. Eine der zweiten Kameraanordnung K2 entsprechende dritte Kameraanordnung K3 mit drei Kameras ist an der Peripherie der zweiten Wendeeinrichtung 150 bei 90° auf das daran vorbeigeführte Bauteil B gerichtet. Eine vierte Kameraanordnung K4 ist im Zentrum der zweiten Wendeeinrichtung 150 auf die Ablagestelle ABS oder die erste Empfangsstelle ES1 in der Empfangseinrichtung 200 gerichtet.

Die Steuerung ECU ist dazu eingerichtet, mittels eines ersten Drehantriebes DA1 die erste Wendeeinrichtung 130 um eine erste Achse (hier die X-Achse) kontrolliert zu drehen und mittels eines ersten Linearantriebes LA1 die erste Wendeeinrichtung 130 längs der ersten Achse kontrolliert zu verfahren.

Die Steuerung ECU ist weiterhin dazu eingerichtet, mittels eines zweiten Drehantriebes DA2 die zweite Wendeeinrichtung 150 um eine zu der ersten Achse (hier die X-Achse) nicht kollineare zweite Achse (hier die Y-Achse) kontrolliert zu drehen, und mittels eines zweiten Linearantriebes LA2 die zweite Wendeeinrichtung 150 längs der zweiten Achse kontrolliert zu verfahren.

Die bildgebenden Sensoren inspizieren die Deck- und/oder Seitenfläche(n) des Bauteils B und liefern dabei auch relevante Daten zur Positionierung der ersten und zweiten Wendeeinrichtungen 130, 150 längs und um deren Achsen, sowie der Aufnehmer 132, 152 und der an ihnen befindlichen Bauteile B und der Empfangsstellen.

Die Bauteilhandhabungsvorrichtung 100 ist mit einer der Ablagestelle ABS zugeordneten Empfangseinrichtung 200 für ein dorthin gefördertes Bauteil B ausgestattet. Der Empfangseinrichtung 200 sind dabei Lage- und Eigenschaftssensoren K4, K5 zugeordnet, die dazu eingerichtet sind, Lagedaten des an die Ablagestelle ABS geförderten Bauteils B, Lagedaten und Eigenschaften von Empfangsstellen ES1, ES2 in der Empfangseinrichtung 200 und der darin befindlichen Bauteile B zu erfassen und für eine Steuerung ECU zur Verfügung zu stellen. Dabei ist der Lage- und Eigenschaftssensor K5 eine fünfte Kameraanordnung, die auf ein zweites Fenster an der zweiten Empfangsstelle ES2 gerichtet ist. Die Steuerung ECU ist dazu eingerichtet, mittels eines dritten Drehantriebes DA3 die Empfangseinrichtung 200 um eine die Ablagestelle ABS enthaltende dritte Achse (hier die Z-Achse) kontrolliert zu drehen und mittels eines dritten und eines vierten Linearantriebes LA3, LA4 die Empfangseinrichtung längs der ersten und der zweiten Achsen kontrolliert zu verfahren. Mittels eines vierten Drehantriebes DA4 verfährt die Steuerung ECU einen durch die Empfangseinrichtung 200 geführten Träger 320 längs der ersten Achse (hier die X-Achse) kontrolliert. Dieser Träger 320 dient dazu, die Bauteile B in vereinzelter Form von der zweiten Wendeeinrichtung 150 aufzunehmen. Die Wendeeinrichtungen 130, 150 und die Drehantriebe DA1, DA2, ... haben jeweils einen mit der Steuerung ECU verbundenen, nicht weiter dargestellten hochauflösenden rotatorischen Winkel-Encoder zur Bestimmung ihrer jeweiligen Rotationsstellung.

In der Empfangseinrichtung 200 dient der vierte Drehantrieb DA4 dazu, durch Steuersignale aus der Steuerung ECU angesteuert, den durch die Empfangseinrichtung 200 geführten Träger 320 längs der ersten Achse (hier der X-Achse) kontrolliert um etwa 100% plus minus maximal 3% des Rastermaßes benachbarter Bauteil-Aufnahmen (Taschen) des Trägers 320 zu verfahren. Das Rastermaß ergibt sich aus dem Mittenabstand zweier aufeinander folgender Taschen. Der dritte Drehantrieb DA3 ist dazu eingerichtet, durch Steuersignale aus der Steuerung ECU angesteuert, in Abhängigkeit von Signalen aus dem bildgebenden Eigenschafts- und Lagesensor im Zentrum der zweiten Wendeeinrichtung 150 eine der Empfangsstellen E1 mit der dort befindlichen Bauteil-Aufnahme des Trägers 320 um die die Ablagestelle enthaltende Z-Achse kontrolliert um bis zu plus minus 6 ° zu drehen.

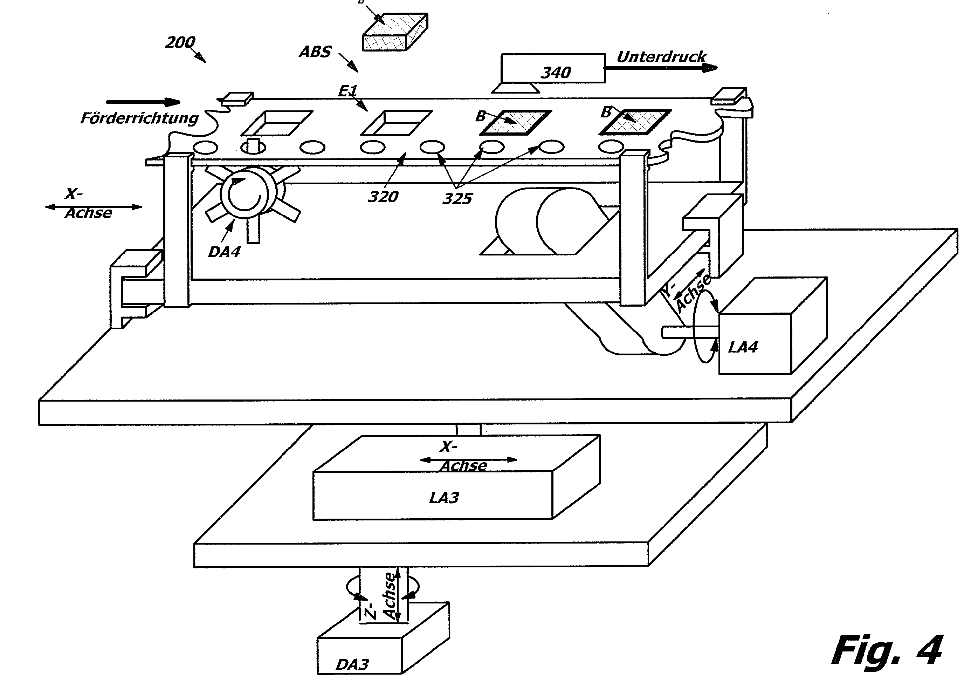

Der vierte Drehantrieb DA4 der Empfangseinrichtung 200 hat in der in Fig. 4 gezeigten Varianten ein Stachelrad, das in Transportlöcher 325 des Trägers 320 (Ablagebandes) eingreift um es in Förderrichtung zu transportieren. Das Stachelrad dreht dabei bevorzugt nur in eine Vorwärts-Richtung.

Bei der Empfangseinrichtung 200 ist in dieser Variante eine Absaug- und/oder Ausblaseinrichtung 340 abstromseitig zur Empfangsstelle ES1 vorgesehen. Diese ist jedoch optional. Damit werden, durch Steuersignale aus der Steuerung ECU angesteuert, als schadhaft oder fehlerhaft platziert erkannte Bauteile aus ihrer Tasche entfernt.

Zum Ansaugen des Bauteils B in den Aufnehmern 132, 152, zum Halten des Bauteils B in den Aufnehmern 132, 152, zum Ablegen des Bauteils B mit oder ohne gesteuertem Abblas-Impuls, und zum freien Abblasen des Bauteils B aus den Aufnehmern 132, 152 sind diese mit einer nicht weiter veranschaulichten Pneumatikeinheit verbunden. Die Pneumatikeinheit beaufschlagt, von der Steuerung ECU kontrolliert, die einzelnen Aufnehmer 132, 152 ventilgesteuert zum jeweils erforderlichen Zeitpunkt oder Zeitraum mit Über- oder Unterdruck um die Bauteile einzeln aufzunehmen, zu halten und wieder abzugeben.

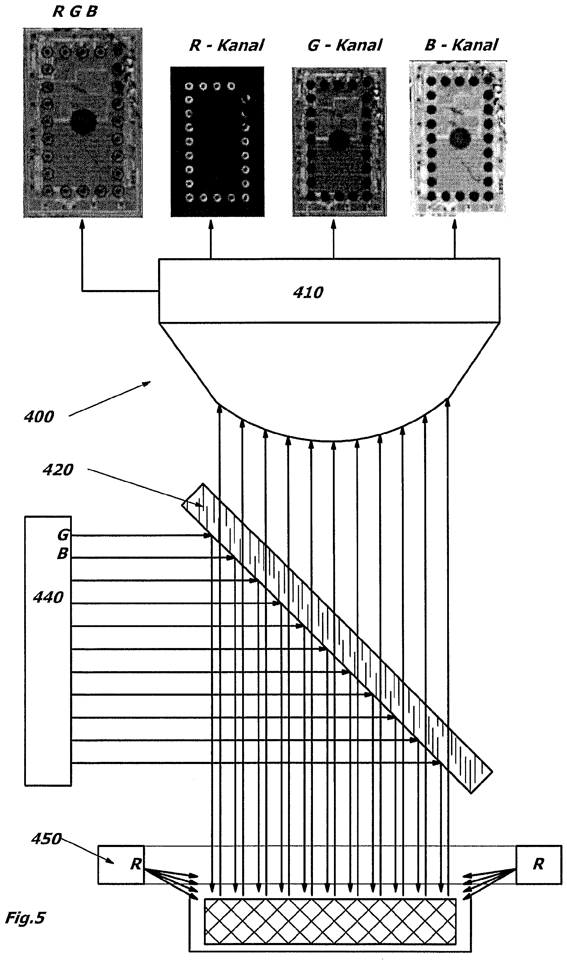

Sofern die mittels der Steuerung ECU und den Lage- und Eigenschaftssensoren an den einzelnen Stationen gewonnenen Inspektionsergebnisse positiv sind, wird das jeweilige Bauteil B in die momentan an der Ablegestelle ABS befindliche Empfangsstelle ES1, also die Tasche des Trägers 320 abgelegt. Sofern die gewonnenen Inspektionsergebnisse negativ sind, wird das Bauteil B um eine weitere Position zu einem ersten Absauger 330 weiter rotiert, wo es von seinem Aufnehmer 152 an der zweiten Wendeeinrichtung 150 abgesogen wird. Sofern sich durch einen diese Empfangsstelle ES1 überwachenden Lage- und Eigenschaftssensor (siehe auch Fig. 5) ergibt, dass das abgelegte Bauteil B nach der Ablage einen Lage- oder Eigenschaftsfehler hat, wird es mittels eines abstromseitig zur Empfangsstelle ES1 befindlichen zweiten Absaugers 340 aus der Tasche des Trägers 320 herausgesaugt. Anschließend wird in diesem Fall, von der Steuerung ECU kontrolliert, die gesamte Empfangseinrichtung 200 zusammen mit dem Träger 320 um den Mittenabstand zweier Taschen des Trägers 320 mit der dritten Linearantriebseinheit LA3 entgegen der Förderrichtung des Trägers 320 zurückgesetzt. Dann wird das nächste Bauteil B an der zweiten Wendeeinrichtung 150 in die freigewordene Tasche des Trägers 320 eingebracht.

Bei einer weiteren Variante ist der ersten Empfangsstelle ES1 eine zusätzliche, nicht weiter veranschaulichte Absaugeinrichtung zugeordnet, um ein schräg liegendes Bauteil an der Empfangsstelle ES1 abzusaugen. Durch den Lage- und Eigenschaftssensor K4 oder durch den Lage- und Eigenschaftssensor K5 am zweiten Fenster können etwaige Qualitätsfehler festgestellt werden. Sofern der Lage- und Eigenschaftssensor K5 einen Qualitätsfehler erfasst, wird die Empfangseinrichtung 200 zusammen mit dem Träger 320 zurücktransportiert, an der Ablagestelle wird dann das Bauteil B aus der Tasche des Trägers 320 abgesaugt.

Eine Verkippung eines schräg liegenden, also nur teilweise im Innern der Tasche des Trägers 320 aufgenommenen oder abgelegten Bauteils an der Bauteil-Ablagestelle ABS / der Empfangsstelle ES1 kann durch einen weiteren Lage- und Eigenschaftssensor K6 erkannt werden, welcher der Empfangsstelle ES1 zugeordnet ist. Dieser Lage- und Eigenschaftssensor K6 ist in der hier veranschaulichten Variante seitlich zum Träger 320 angeordnet und erfasst die Empfangsstelle ES1 über einen Umlenkspiegel über die Oberkante des Trägers 320. Dabei ist der Sensor K6 in der hier veranschaulichten Variante fest mit der Empfangseinrichtung 200 derart verbunden, dass deren Verstell-Bewegungen, oder genauer gesagt des Rahmens 350 der Empfangseinrichtung 200 längs der ersten Achse (hier die X-Achse), bewirkt durch den Antrieb LA3, längs der zweiten Achse (hier die Y-Achse), bewirkt durch den Antrieb LA4, oder um die dritte Achse (hier die Z-Achse), bewirkt durch den Antrieb DA3 unmittelbar durch den Sensor K6 mit ausgeführt werden. Damit haben die von dem Sensor K6 erfassten Informationen eine geringere Ungenauigkeit/ Unschärfe, weil der zu erfassende Ort sich zu dem Sensor K6 nicht räumlich bewegt, wie dies zum Beispiel bei einem extern zur Empfangseinrichtung 200 befindlichen Sensor der Fall ist. Die vierte Kameraanordnung K4 im Zentrum der zweiten Wendeeinrichtung 150, gerichtet auf die Ablagestelle ABS / die erste Empfangsstelle ES1 in der Empfangseinrichtung 200 stellt zum Beispiel einen derartigen, extern zur Empfangseinrichtung 200 befindlichen Sensor dar.

Insbesondere ist der Sensor K6 mit dem Rahmen 350 fest verbunden, in dem der Träger 320 mit den Taschen zur Aufnahme der Bauteile B geführt ist. Damit besteht eine räumlich klar definierte Mess-Situation für den Sensor K6, den oberen Rand der Tasche des Trägers 320 an der Ablagestelle in Bezug auf die Lage des Bauteils zu erfassen.

Dies eröffnet die Möglichkeit, auch bei sehr hohen Transportgeschwindigkeiten und daraus resultierenden kurzen Zeiten zur Situationserfassung, Auswertung und Reaktion pro Bauteil, die richtige Maßnahme zu ergreifen. Die richtige Maßnahme kann dabei entweder ein Weitertransport des Trägers 320 sein, weil das Bauteil korrekt in der untersuchten Tasche liegt, oder ein Durchführen einer Absaugung des Bauteils aus der untersuchten Tasche des Trägers 320 und ggf. erneute Befüllung der untersuchten Tasche mit einem anderen Bauteil B.

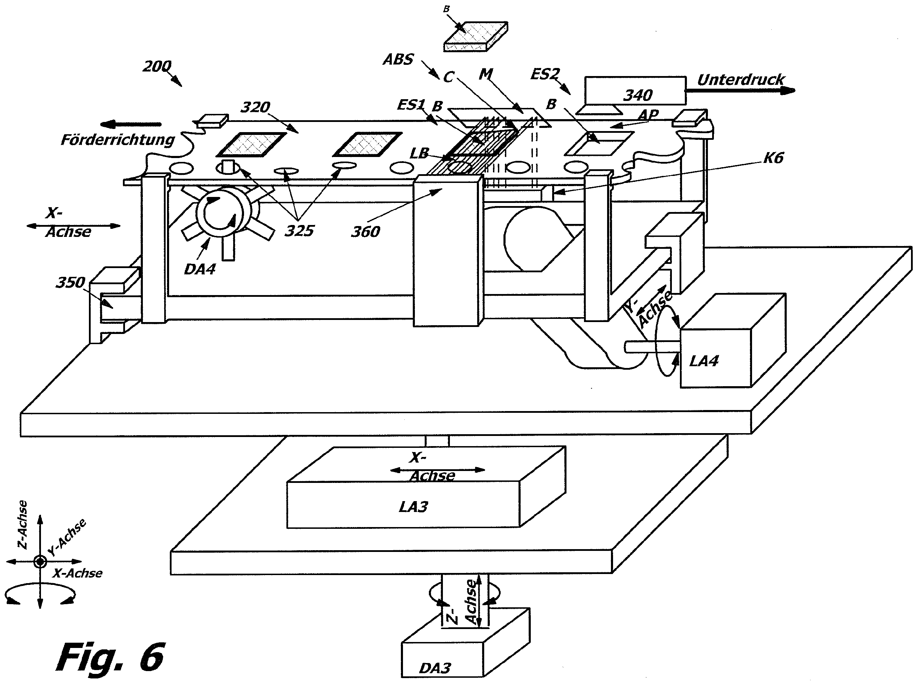

Der Sensor K6 ist in der hier veranschaulichten Variante ein einfacher Streifen-Lichtsensor, der auf der, in Fig. 6 hinteren, Längsseite des Rahmens 350 ortsfest angeordnet ist. Dieser (Streifen-Licht-)sensor K6 wird von einem Lichtband LB aus einer, in Fig. 6 vorderen, Längsseite des Rahmens 350 ortsfest angeordneten Streifen-Lichtquelle 360 bestrahlt. Genauer gesagt ist gegenüber der Streifen-Lichtquelle 360 ein dem Sensor K6 zugeordneter Umlenkspiegel M angeordnet, der das parallel zur Oberseite des Trägers 320 aus der Lichtquelle 360 ausgesendete Lichtband LB zu dem (Streifen-Licht-)sensor K6 hin umlenkt. Dabei überstreicht das Lichtband LB den Träger 320 in minimalem Abstand zu dessen Oberseite quer zur Förderrichtung des Trägers 320 auf einer die Abmessung der Tasche in Förderrichtung beidseitig überschreitenden Länge. Ein nicht vollständig in einer Tasche des Trägers 320 abgelegtes Bauteil B ragt aus der Tasche zumindest teilweise heraus und schattet das Lichtband LB demzufolge entsprechend teilweise ab. Diese in Fig. 6 veranschaulichte (teilweise) Abschattung ist mit dem (Streifen-Licht-)sensor K6 sehr leicht und effizient zu erfassen und von diesem an die Steuerung ECU zu signalisieren.

In der hier veranschaulichten Variante ist der (Streifen-Licht-)sensor K6 aus Platzgründen seitlich so an dem Rahmen 350 ortsfest angeordnet, dass der Umlenkspiegel M das die Oberseite des Trägers 320 überstreichende Lichtband LB zu dem am Rahmen 350 befestigten (Streifen-Licht-)sensor K6 umlenkt. Auch die Lichtquelle 360 könnte analog zu dem (Streifen-Licht-)sensor K6 unten an dem Rahmen 350 befestigt sein und über einen zweiten, nicht gezeigten Umlenkspiegel das Lichtband LB über den Träger 320 in minimalem Abstand zu dessen Oberseite quer zur Förderrichtung des Trägers 320 zu dem Umlenkspiegel M lenken.

Anstelle des einfachen (Streifen-Licht-)sensors kann als Sensor K6 kann auch eine Schwarz-Weiß-Kamera oder eine Farb-Kamera vorgesehen sein. Bei eindeutigen, ausreichenden Licht- und Sichtverhältnissen für den Sensor K6 sowohl in der Variante als (Streifen-Licht-)sensor als auch als Kamera kann die Streifen-Lichtquelle 360 auch entfallen. Die Streifen-Lichtquelle 360 kann aus mehreren einzelnen, nebeneinander positionierten Lichtquellen, aber auch als Einzellichtquelle mit entsprechenden, den Lichtstrahl formenden optischen Elementen ausgestaltet sein. Das abgestrahlte Licht kann im sichtbaren oder im unsichtbaren Spektrum liegen und ist auf das Empfangsspektrum des Sensor K6 abgestimmt.

So ist sehr sicher und auch sehr schnell zu erkennen, wenn ein in der Tasche des Trägers 320 abgelegtes Bauteil nicht korrekt in der Tasche abgelegt wurde und stattdessen verkippt in der Tasche liegt, also mit einer Ecke oder Kante des Bauteils über deren oberen Rand (teilweise) heraussragt. Dies wäre zwar auch mit der senkrecht von oben auf die Tasche gerichteten Sensoranordnung K4 möglich. Allerdings müsste dann der Träger 320 solange mit der soeben befüllten Tasche stehen bleiben, bis der Sensor K4 im Zentrum der zweiten Wendeeinrichtung 152 wieder freie Sicht zwischen zwei Aufnehmern der zweiten Wendeeinrichtung 152 auf die Ablagestelle ABS oder die erste Empfangsstelle ES1 in der Empfangseinrichtung 200 hat. Dies stellt eine zeitliche Restriktion auf den Durchsatz dar, da die Neuausrichtung der nächsten, zu befüllenden Tasche ebenfalls ausreichend Zeit benötigt.

Der vorstehend im Detail erläuterte, quer über die Oberkante des Trägers 320 im Bereich der an der Bauteil-Ablagestelle ABS befindlichen Tasche inspizierende Sensor K6 hat diese Einschränkung nicht, da er seitlich von dem Träger 320 im Gehäuse am Rahmen der Empfangseinrichtung 200 integriert ist. Er ist von außen praktisch nicht sichtbar und blickt mittels des Umlenkspiegels über die Oberkante des Trägers 320.

Dieser Sensor K6 und ggf. die Lichtquelle sind fest mit dem Rahmen 350 der Empfangseinrichtung 200 verbunden und werden gemeinsam bei der Ausrichtung der Tasche zur dem das Bauteil B ablegenden Aufnehmer der zweiten Wendeeinrichtung 152 (in der 6-Uhr Position) mit der Empfangseinrichtung 200 bewegt. Demgegenüber sind die Sensoren K4, K5 ortsfest angeordnet. Diese erschwert die sichere und schnelle Bildauswertung, weil sich der Rahmen 350 der Empfangseinrichtung 200 relativ zu diesen Sensoren K4, K5 im Betrieb bewegt.

Sofern der Sensor K6 ein in der Tasche verkippt liegendes Bauteil erkennt und dies der Steuerung ECU signalisiert, veranlasst diese Steuerung ECU ein Zurücksetzen der Empfangseinrichtung 200, genauer gesagt deren Rahmen 320 mit dem darin befindlichen Träger zu einer Absaugposition. Zum Entfernen des verkippten Bauteils bewegt sich der Absauger 340 z.B. schräg von oben oder von der Seite auf die Absaugposition zu. Zeitgleich bewegt sich der Rahmen 320 mit der Tasche, in der sich das verkippte Bauteil befindet, durch den Linearantrieb LA3 in x-Richtung, auf die Absaugposition AP zu. Der den Träger fördernde Drehantrieb DA4 rotiert dabei nicht. In einer anderen Variante ist die Empfangseinrichtung 200 als Ganzes, mit ihren Antrieben auf einem Schlitten x-Richtung längsverschieblich auf einer starren Grundplatte montiert. Dabei ist die Empfangseinrichtung 200 samt der Grundplatte für den Betrieb unter der zweiten Wendeeinrichtung 152 in einer Arbeitsposition fixierbar und zum Beispiel zu Wartungszwecken gegenüber der zweiten Wendeeinrichtung 152 verschiebbar und dann in einer Wartungsposition fixierbar.

So kann eine etwaige Verkippung oder ein Überstand eines nicht korrekt in der Tasche des Trägers abgelegten Bauteils erkannt und behoben werden.

Ein Verfahren zum Entnehmen fehlerhafter Bauteile B aus der Empfangseinrichtung 200 führt in einer Variante folgende Schritte aus:
Ein in einer Tasche des Trägers 320 nicht korrekt abgelegtes Bauteil B wird an der ersten Empfangsstelle ES1 erfasst, wobei hierfür insbesondere die Empfangseinrichtung 200 mit einer Sensoranordnung in der oben beschriebenen Weise ausgestattet ist;
die Empfangseinrichtung 200 wird entgegen der Förderrichtung so weit bewegt, so dass das nicht korrekt abgelegte Bauteil B sich an einer Absaugposition befindet, ohne dass dabei der in der Empfangseinrichtung 200 geführte Träger 320 gefördert wird;
das nicht korrekt abgelegte Bauteil B wird an der Absaugposition aus der Tasche des Trägers 320 abgesaugt;
Die Empfangseinrichtung 200 wird in der Förderrichtung so weit bewegt, dass sich die entleerte Tasche an der ersten Empfangsstelle ES1 befindet, ohne dass dabei der in der Empfangseinrichtung 200 geführte Träger 320 gefördert wird; und
Ablegen eines Bauteils B in der Tasche des Trägers 320 an der ersten Empfangsstelle ES1.

Die Absaugposition kann mit der zweiten Empfangsstelle ES2 zusammenfallen, wie in der Figur 6 gezeigt. Die Absaugposition kann aber auch an einer von der zweiten Empfangsstelle ES2 verschiedenen Position, aufstromseitig oder abstromseitig zur Ablagestelle ABS, vorgesehen sein. Dabei kann die Absaugposition in Förderrichtung des in der Empfangseinrichtung geführten Trägers von der zweiten Empfangsstelle ES2 weiter beanstandet sein als von der ersten Empfangsstelle ES1. Die Absaugeinrichtung 450 kann auch dazu eingerichtet sein, aus einer zurückgezogenen (Ruhe-)Stellung zu der Absaugposition hin geschwenkt oder bewegt zu werden.

Wie in der Fig. 2 in Verbindung mit der Fig. 1 veranschaulicht ist, ist die Kameraanordnung K1 als Lage- und Eigenschaftssensor im Zentrum der ersten Wendeeinrichtung 130 auf den Bauteilvorrat gerichtet. Damit wird die Deckfläche D2 des Bauteils B auf Lage und Fehler inspiziert. Dabei ist die Kameraanordnung K1 dazu eingerichtet, einen Bildeinzug jeweils während der Wendebewegung der ersten Wendeeinrichtung 130 zwischen zwei benachbarten Aufnehmern 132 hindurch auszuführen. Die Steuerung erzeugt aus diesen Bilddaten entsprechende Korrekturbewegungen der Ausstoßeinheit, des Bauteilvorrats bzw. des Wafers und der ersten Wendeeinrichtung 130.

Die zweite Kameraanordnung K2 ist als Lage- und Eigenschaftssensor mit ihren drei Kameras an der Peripherie der ersten Wendeeinrichtung 130 bei etwa 90° auf die drei Seiten S2, S4 und D1 des Bauteils B gerichtet. Eine Draufsicht auf die Kameraanordnung K2 mit ihren drei Kameras K2-1, K2-2 und K2-3 ist in Fig. 3 veranschaulicht. Hierbei inspiziert die mittlere Kamera K2-2 die Deckfläche D1 des Bauteils B und die beiden äußeren Kamera K2-1 und K2-3 über jeweilige Spiegel SP1 und SP2 die Seitenflächen S2 und S4 des Bauteils B. Aus den dabei erfassten Bildeinzügen lässt sich neben etwaigen Fehlern des Bauteils B an diesen Flächen auch die genaue Lage und Rotation des Bauteils B an seinem Aufnehmer 132 bestimmen. Diese Information wird in der Steuerung ECU dazu verwendet, die Ausrichtung der ersten Wendeeinrichtung 130 sowie der zweiten Wendeeinrichtung 150 längs ihrer Achsen und Rotationsorientierung zu verändern, wenn das inspizierte Bauteil B an der Übergabestelle ÜS von der ersten Wendeeinrichtung 130 zu der zweiten Wendeeinrichtung 150 übergeben wird.

Die dritte Kameraanordnung K3 ist als Lage- und Eigenschaftssensor mit ihren drei Kameras extern an der Peripherie der zweiten Wendeeinrichtung 150 bei etwa 90° auf die drei Seiten S1, S3 und D2 des Bauteils B gerichtet. Diese Kameraanordnung K3 entspricht in ihrem Aufbau und ihrer Anordnung der Kameraanordnung K2 mit ihren drei Kameras und beiden Spiegeln in Fig. 3. Aus den dabei erfassten Bildeinzügen lässt sich neben etwaigen Fehlern des Bauteils B an diesen Flächen auch die genaue Lage und Rotation des Bauteils B an seinem Aufnehmer 152 der zweiten Wendeeinrichtung 150 bestimmen. Diese Information wird in der Steuerung ECU dazu verwendet, die Ausrichtung der zweiten Wendeeinrichtung 150 sowie der Empfangseinrichtung 200 längs ihrer Achsen und Rotationsorientierungen zu verändern, wenn das inspizierte Bauteil B an der Übergabestelle ÜS von der zweiten Wendeeinrichtung 150 in die an der Ablegestelle ABS befindliche Empfangsstelle ES1, also die Tasche des Trägers 320 abgelegt wird.

Die vierte Kameraanordnung K4 ist als Lage- und Eigenschaftssensor im Zentrum der zweiten Wendeeinrichtung 150 auf die Empfangsstelle E1 in der Empfangseinrichtung 200 gerichtet. Auch diese Kameraanordnung K4 ist dazu eingerichtet, einen Bildeinzug jeweils während der Wendebewegung der zweiten Wendeeinrichtung 150 zwischen zwei benachbarten Aufnehmern hindurch auszuführen. Die Steuerung ECU veranlasst dann entsprechende Korrekturbewegungen der zweiten Wendeeinrichtung 150 und der Empfangseinrichtung 200.

Der in Fig. 5 veranschaulichte Lage- und Eigenschaftssensor 400 ist als bildgebender Sensor eine Variante der Kameraanordnungen K1 - K5. Dieser Sensor 400 hat einen das sichtbare Lichtspektrum aufnehmenden Kamera-Chip 410. Bei diesem bildgebenden Sensor 400 sind die drei voneinander abweichenden Erfassungsspektren als roter Farbbereich - 630nm plus minus 30 nm -, als grüner Farbbereich - 530 nm plus minus 60 nm -, und als blauer Farbbereich - 460nm plus minus 50 nm - eines Farbsensors ausgestaltet.

Dem bildgebenden Sensor 400 ist ein halbdurchlässiger Spiegel 420 zugeordnet, der unter einem Winkel von etwa 45° zur optischen Achse des Kamera-Chips 410 angeordnet ist. Der halbdurchlässige Spiegel 420 dient dazu, farbiges Licht zweier Erfassungsspektren, hier dem grünen Farbbereich und dem blauen Farbbereich, aus entsprechenden Lichtquellen 440 optisch einzukoppeln und auf eine Deckfläche des Bauteils B zu richten. Dieses auf das Bauteil B gerichtete Licht im grünen und im blauen Farbbereich erfasst der Kamera-Chip 410. Je nach räumlichen Gegebenheiten können auch andere Umlenkspiegel, Prismen, Farbfilter oder Linsen vorgesehen sein.

Eine weitere Lichtquelle 450 ist in einer Ausgestaltung als Ringlichtquelle um die an der Ablegestelle ABS befindliche Empfangsstelle ES1 angeordnet und liefert Streulicht unter einem Winkel von etwa 5° - 45° im roten Farbbereich auf die Deckfläche des Bauteils B. Auch dieses auf das Bauteil B gerichtete Licht im roten Farbbereich erfasst der Kamera-Chip 410.

Einzelne der optisch wirksamen Elemente und/oder der Strahlungsquellen können dazu eingerichtet sein, unabhängig von anderen ausgerichtet und/oder justiert / fokussiert zu werden.

Der Kamera-Chip 410 ist in der vorliegenden Variante eine Farbkamera mit drei einzelnen Kanälen R, G, B. Es kann aber auch eine Kamera mit mehreren Kanälen sein. Die drei Farbkanäle der Kamera sind getrennt voneinander ansprechbar/ auszulesen. Mit einer einzigen Bildaufnahme wird das Bauteil B auf Fehler inspiziert, zum Beispiel das schräge Ablegen des Bauteils B, so dass es nicht korrekt in der vorgesehenen Tasche des Trägers 320 positioniert ist, oder auf Qualitätsmängel. Außerdem werden durch diese einzige Bildaufnahme die exakten Positionsdaten der Tasche des Trägers 320 für das Ablegen des nächsten Bauteils B erfasst. Die aus den einzelnen Farbkanälen zu gewinnende Information teilt sich wie folgt auf: Bildkanal 1 mit Beleuchtungstyp 1: Position der Ablagetasche des Ablagebandes zur Positionierung des nächsten Bauteils. Bildkanal 2 mit Beleuchtungstyp 2: Qualitätsinspektion des Bauteils (Risse, Lasermarken, Ausbrüche, ...). Bildkanal 3 mit Beleuchtungstyp 3: Zusatzinspektionen für spezielle Bauteile oder kundenspezifische Fehler.

Durch die hier vorgestellte bildgebende Sensorik sind weniger Bildeinzüge erforderlich als mit herkömmlichen Sensoranordnungen um eine Schlechtteilausschleusung und eine Positionierung der Aktoren zu realisieren.

Es sei bemerkt, dass obwohl hier numerische Bereiche und numerische Werte offenbart wurden, alle numerischen Werte zwischen den offenbarten Werten und jedem numerischen Unterbereich innerhalb der genannten Bereiche als ebenfalls offenbart anzusehen sind.

Die vorangehend beschriebenen Varianten der Vorrichtung sowie deren Aufbau- und Betriebsaspekte dienen lediglich dem besseren Verständnis der Struktur, der Funktionsweise und der Eigenschaften; sie schränken die Offenbarung nicht etwa auf die Ausführungsbeispiele ein. Die Fig. sind teilweise schematisch, wobei wesentliche Eigenschaften und Effekte zum Teil deutlich vergrößert dargestellt sind, um die Funktionen, Wirkprinzipien, technischen Ausgestaltungen und Merkmale zu verdeutlichen. Dabei kann jede Funktionsweise, jedes Prinzip, jede technische Ausgestaltung und jedes Merkmal, welches/welche in den Fig. oder im Text offenbart ist/sind, mit allen Ansprüchen, jedem Merkmal im Text und in den anderen Fig., anderen Funktionsweisen, Prinzipien, technischen Ausgestaltungen und Merkmalen, die in dieser Offenbarung enthalten sind oder sich daraus ergeben, frei und beliebig kombiniert werden, so dass alle denkbaren Kombinationen der beschriebenen Vorgehensweise zuzuordnen sind. Dabei sind auch Kombinationen zwischen allen einzelnen Ausführungen im Text, das heißt in jedem Abschnitt der Beschreibung, in den Ansprüchen und auch Kombinationen zwischen verschiedenen Varianten im Text, in den Ansprüchen und in den Fig. umfasst. Der Schutzbereich des europäischen Patents und der europäischen Patentanmeldung wird durch die Patentansprüche bestimmt. Die Beschreibung und die Zeichnungen sind jedoch zur Auslegung der Patentansprüche heranzuziehen.

## Patentansprüche

1. Empfangseinrichtung (200) für Bauteile (B), die dazu eingerichtet ist, relativ zu einer Ablagestelle (ABS) mittels wenigstens eines Linearantriebes (LA4) zumindest teilweise längs einer ersten, zweiten und/oder dritte Achsen (X-, Y-, Z-Achse) kontrolliert verstellt zu werden
und/oder eines Antriebes (DA4) einen durch die Empfangseinrichtung (200) geführten Träger (320) längs einer der ersten und/oder zweiten Achsen (X-, Y-Achse) kontrolliert zu verfahren, und die Empfangseinrichtung einen Lagesensor (K6) aufweist, der einer Bauteil-Ablagestelle (ABS) zugeordnet ist um ein nur teilweise in einer Tasche des Trägers (320) abgelegtes Bauteil (B) an der Bauteil-Ablagestelle (ABS) zu erfassen, wobei der Lagesensor (K6) seitlich zum Träger (320) mit der Empfangseinrichtung (200) derart verbunden ist, dass der Lagesensor (K6) Bewegungen der Empfangseinrichtung (200) unmittelbar mit ausführt.

2. Empfangseinrichtung (200) für Bauteile (B) nach Anspruch 1, die dazu eingerichtet ist, mittels eines Drehantriebes (DA3) zumindest teilweise um eine die Ablagestelle (ABS) enthaltende dritte Achse (Z-Achse) kontrolliert zu drehen.

3. Empfangseinrichtung (200) für Bauteile (B) nach Anspruch 1 oder 2, bei der der Sensor (K6) Bewegungen der Empfangseinrichtung (200) längs der ersten Achse (X-Achse), bewirkt durch den Antrieb (LA3), und/oder längs der zweiten Achse (Y-Achse), bewirkt durch den Antrieb (LA4), und/oder um die dritte Achse (Z-Achse), bewirkt durch den Antrieb (DA3), mit der Empfangseinrichtung (200) ausführt.

4. Empfangseinrichtung (200) für Bauteile (B) nach einem der Ansprüche 1 - 3, bei der der Sensor (K6) mit einem Rahmen (350) der Empfangseinrichtung (200) fest verbunden ist, in dem der Träger (320) mit den Taschen zur Aufnahme der Bauteile (B) geführt ist, um einen oberen Rand der Tasche des in dem Rahmen (350) geführten Trägers (320) an der Ablagestelle (ABS) in Bezug auf die Lage des Bauteils (B) zu erfassen.

5. Empfangseinrichtung (200) für Bauteile (B) nach einem der vorhergehenden Ansprüche, bei der der Sensor (K6) als Streifen-Lichtsensor ausgestaltet ist, der an einer Seite des Rahmens (350) ortsfest angeordnet ist und dazu eingerichtet ist, ein Lichtband (LB) aus einer an der gegenüberliegenden Seite des Rahmens (350) angeordneten Streifen-Lichtquelle (360) zu erfassen.

6. Empfangseinrichtung (200) für Bauteile (B) nach Anspruch 4 oder 5, bei der Sensor (K6) dazu eingerichtet ist, nachdem dieses Lichtband (LB) zumindest annähernd parallel zur Oberseite des Trägers (320) quer zur Förderrichtung des Trägers (320) auf einer der Abmessung der Tasche in Förderrichtung zumindest entsprechenden Länge überstrichen hat, zu erfassen und dieses erfasste Lichtband (LB) über seine Länge auszuwerten, wobei das Lichtband (LB) so zu dem oberen Rand der Tasche des in dem Rahmen (350) geführten Trägers (320) an der Ablagestelle (ABS) ausgerichtet ist, dass ein nicht vollständig in der Tasche des Trägers (320) abgelegtes Bauteil (B) aus der Tasche zumindest teilweise heraus ragt und das Lichtband (LB) demzufolge entsprechend zumindest teilweise abschattet, und wobei der Sensor K6 dazu eingerichtet ist, dies an eine Steuerung (ECU) zu signalisieren.

7. Empfangseinrichtung (200) für Bauteile (B) nach einem der vorhergehenden Ansprüche, bei der der Sensor (K6) seitlich unterhalb des Trägers (320) an dem Rahmen (350) angeordnet ist, und dass ein Umlenkspiegel (M) vorgesehen ist, der das die Oberseite des Trägers (320) überstreichende Lichtband (LB) zu dem am Rahmen (350) befestigten Sensor (K6) umlenkt, und/oder die Lichtquelle (360) seitlich unterhalb des Trägers (320) an dem Rahmen (350) angeordnet ist und ein zweiter Umlenkspiegel das Lichtband (LB) über den Träger (320) über dessen Oberseite zu dem Umlenkspiegel (M) lenkt.

8. Empfangseinrichtung (200) für Bauteile (B) nach einem der vorhergehenden Ansprüche, bei der der Sensor (K6) als Schwarz-Weiß-Kamera oder als Farb-Kamera ausgestaltet ist.

9. Empfangseinrichtung (200) nach einem der vorhergehenden Ansprüche, bei der ein bildgebender Eigenschafts- und/oder Lagesensor (K4) zum Ermitteln von Eigenschaften und/oder der Lage eines zu empfangenden Bauteils (B) in Bezug auf dessen Eigenschaften und/oder seiner Lage zu wenigstens einer der Empfangsstellen (ES1, ES2) vorgesehen ist, mit dem Ziel der Erzeugung von Korrekturanweisungen bei Eigenschafts- und/oder Lagefehlern des zu empfangenden Bauteils (B) bzw. der Empfangsstelle durch die Steuerung (ECU) zur Veranlassung entsprechender Korrekturbewegungen, und/oder
bei der der vierte Drehantrieb (DA4) dazu eingerichtet ist, durch Steuersignale aus der Steuerung (ECU) angesteuert, mittels einer mechanischen Traktion den durch die Empfangseinrichtung (200) geführten Träger (320) längs einer der ersten und/oder zweiten Achsen (X-, Y-Achse) kontrolliert zu verfahren, und/oder bei der der dritte Drehantrieb (DA3) dazu eingerichtet ist, durch Steuersignale aus der Steuerung (ECU) angesteuert, in Abhängigkeit von Signalen aus dem bildgebenden Eigenschafts- und/oder Lagesensor wenigstens eine der Empfangsstellen (ES1, ES2) mit der dort befindlichen Bauteil-Aufnahme des Trägers (320) um die die Ablagestelle (ABS) enthaltende dritte Achse (Z-Achse) kontrolliert zu drehen, und/oder bei der der wenigstens eine Linearantrieb dazu eingerichtet ist, durch Steuersignale aus der Steuerung (ECU) angesteuert, die Empfangseinrichtung (200) kontrolliert um einen Teil des Rastermaßes benachbarter Bauteil-Aufnahmen des Trägers (320) längs einer der ersten, zweiten und/oder dritten Achsen (X-, Y-, Z-Achse) kontrolliert zu verfahren, und/oder
bei der der Drehantrieb (DA4) dazu eingerichtet ist, den durch die Empfangseinrichtung (200) geführten Träger (320) entsprechend einem Rastermaß benachbarter Bauteil-Aufnahmen des Trägers (320) längs einer der ersten und/oder zweiten Achsen (X-, Y-Achse) vorwärts zu fördern.

10. Empfangseinrichtung (200) nach einem der vorhergehenden Ansprüche, wobei eine Absaug- und/oder Ausblaseinrichtung (340) vorgesehen ist, um aus wenigstens einer der Empfangsstellen (ES1, ES2) in der Empfangseinrichtung (200) und/oder dem in der Empfangseinrichtung (200) geführten Träger (320) ein als schadhaft und/oder fehlerhaft platziert erkanntes Bauteil (B) zu entfernen, und/oder wobei die Empfangseinrichtung Bauteile von einer Wendeeinrichtung (150) empfängt, deren Drehachse im Wesentlichen parallel zur Förderrichtung der Empfangseinrichtung (200) orientiert ist, oder wobei die Empfangseinrichtung (200) Bauteile (B) von einer Wendeeinrichtung (150) empfängt, deren Drehachse im Wesentlichen quer zur Förderrichtung der Empfangseinrichtung (200) orientiert ist.

11. Empfangseinrichtung (200) nach einem der Ansprüche 1 bis 10, wobei im Zentrum der Wendeeinrichtung (150) ein bildgebender Eigenschafts- und/oder Lagesensor (K4) zum Ermitteln von Eigenschaften und/oder der Lage eines zu empfangenen Bauteils bzw. zum Ermitteln der Lage von Empfangsstellen in der Empfangseinrichtung und/oder darin befindlichen Bauteils vorgesehen ist, und der dazu eingerichtet ist, zwischen am Umfang der Wendeeinrichtung (150) befindlichen benachbarten Aufnehmern (152) hindurch Bildeinzüge wenigstens einer der Ablagestellen (ABS)) oder der Empfangsstellen (ES1, ES2) in der Empfangseinrichtung (200) auszuführen.

12. Empfangseinrichtung (200) nach einem der vorhergehenden Ansprüche, wobei die Empfangseinrichtung relativ zu der Ablagestelle (ABS) mittels eines Linearantriebes zumindest teilweise längs einer ersten Achse (X-Achse) kontrolliert in beide Richtungen zu verfahren ist, und/oder mittels eines Drehantriebes (DA4) ein durch die Empfangseinrichtung (200) geführter Träger (320) längs einer der ersten und/oder zweiten Achsen kontrolliert in einer Förderrichtung des Trägers (320) zu verfahren ist, und der durch die Empfangseinrichtung (200) geführte Träger (320) mit zwei Empfangsstellen (ES1, ES2) ausgestattet ist, welche zu einer Ablagestelle (ABS) für Bauteile (B) durch kontrolliertes Betätigen der Antriebe zumindest annähernd fluchtend auszurichten sind, und ein bildgebender Eigenschafts- und/ oder Lagesensor (K4) Eigenschaften und/oder Lage eines in Bezug auf dessen Eigenschaften und/oder seine Lage zu untersuchendes Bauteil in wenigstens einer der Empfangsstellen (ES1, ES2) in der Empfangseinrichtung liefert, wobei basierend auf Bilddaten aus dem Eigenschafts- und/ oder Lagesensor Korrekturanweisungen bei Eigenschafts- und/oder Lagefehlern des Bauteils durch eine Steuerung (ECU) zur Veranlassung entsprechender Korrekturbewegungen der Empfangseinrichtung (200) und/oder des in ihr geführten Trägers (320) erfolgen, und der Empfangseinrichtung (200) eine Absaug- und/oder Ausblaseinrichtung (340) zugeordnet ist, um aus wenigstens einer der Empfangsstellen (ES1, ES2) in der Empfangseinrichtung (200) und/oder dem in der Empfangseinrichtung (200) geführten Träger (320) ein als schadhaft und/oder fehlerhaft platziert erkanntes Bauteil (B) zu entfernen.

13. Empfangseinrichtung (200) nach einem der vorhergehenden Ansprüche, wobei die Absaugposition entweder mit der Ablagestelle (ABS) zusammenfällt oder an einer von der zweiten Empfangsstelle (ES2) verschiedenen Position, aufstromseitig oder abstromseitig relativ zur Ablagestelle (ABS) vorgesehen ist, und/oder wobei die Absaugposition (ABS) in Förderrichtung des in der Empfangseinrichtung (200) geführten Trägers von der zweiten Empfangsstelle (ES2) weiter beanstandet ist als von der ersten Empfangsstelle (ES1), und/oder wobei die Absaug- und/oder Ausblaseinrichtung (340) dazu eingerichtet ist, aus einer zurückgezogenen (Ruhe-)Stellung zu der Absaugposition hin geschwenkt oder bewegt zu werden um ein als schadhaft und/oder fehlerhaft platziert erkanntes Bauteil (B) zu entfernen.

14. Verfahren zum Entnehmen fehlerhafter Bauteile (B) aus einer Empfangseinrichtung (200) nach Anspruch 1, wobei das Verfahren folgende Schritte aufweist:
- Erfassen eines nicht korrekt abgelegten Bauteils (B) in einer Tasche des Trägers (320) für ein Bauteil (B) an der ersten Empfangsstelle (ES1),
- Bewegen der Empfangseinrichtung (200) mittels eines Linearantriebes (LA3) entgegen der Förderrichtung, so dass das nicht korrekt abgelegte Bauteil (B) sich an einer Absaugposition befindet, ohne dabei den in der Empfangseinrichtung (200) geführten Träger (320) zu fördern,
- Absaugen des nicht korrekt abgelegten Bauteils (B) an der Absaugposition aus der Tasche des Trägers;
- Bewegen der Empfangseinrichtung (200) mittels des Linearantriebes (LA3) in der Förderrichtung, so dass eine leere Tasche für ein Bauteil (B) sich an der ersten Empfangsstelle (ES1) befindet, ohne dabei den in der Empfangseinrichtung (200) geführten Träger (320) zu fördern,
Ablegen eines Bauteils (B) in der Tasche des Trägers (320) an der ersten Empfangsstelle (ES1).

## Claims

1. Receiving device (200) for components (B), which is set up to be moved in a controlled manner relative to a deposit point (ABS) by means of at least one linear drive (LA4) at least partially along a first, second and/or third axis (X-, Y-, Z-axis)
and/or a drive (DA4) to move a carrier (320) guided by the receiving device (200) in a controlled manner along one of the first and/or second axes (X-, Y-axis), and the receiving device has a position sensor (K6) which is assigned to a component depositing point (K6), (ABS) in order to detect a component (B) deposited only partially in a tray of the carrier (320) at the component depositing point (ABS), the position sensor (K6) being connected laterally to the carrier (320) to the receiving device (200) in such a way that the position sensor (K6) also directly executes movements of the receiving device (200).

2. Receiving device (200) for components (B) according to claim 1, which is set up to rotate in a controlled manner by means of a rotary drive (DA3) at least partially about a third axis (Z axis) containing the deposit point (ABS).

3. Receiving device (200) for components (B) according to claim 1 or 2, in which the sensor (K6) executes movements of the receiving device (200) along the first axis (X-axis), effected by the drive (LA3), and/or along the second axis (Y-axis), effected by the drive (LA4), and/or about the third axis (Z-axis), effected by the drive (DA3), with the receiving device (200).

4. Receiving device (200) for components (B) according to one of the claims 1 - 3, in which the sensor (K6) is fixedly connected to a frame (350) of the receiving device (200), in which the carrier (320) with the pockets for receiving the components (B) is guided, in order to detect an upper edge of the pocket of the carrier (320) guided in the frame (350) at the deposit point (ABS) with respect to the position of the component (B).

5. Receiving device (200) for components (B) according to one of the preceding claims, in which the sensor (K6) is designed as a strip light sensor which is arranged in a fixed position on one side of the frame (350) and is set up to detect a light band (LB) from a strip light source (360) arranged on the opposite side of the frame (350).

6. Receiving device (200) for components (B) according to claim 4 or 5, in which sensor (K6) is arranged to detect, after this light band (LB) has swept at least approximately parallel to the upper side of the carrier (320) transversely to the conveying direction of the carrier (320) over a length at least corresponding to the dimension of the pocket in the conveying direction, and to evaluate this detected light band (LB) over its length, wherein the light band (LB) is aligned with the upper edge of the pocket of the carrier (320) guided in the frame (350) at the deposit point (ABS) in such a way that a component (B) not completely deposited in the pocket of the carrier (320) projects at least partially out of the pocket and the light band (LB) is accordingly at least partially shaded, and wherein the sensor K6 is arranged to signal this to a control unit (ECU).

7. Receiving device (200) for components (B) according to one of the preceding claims, in which the sensor (K6) is arranged laterally below the carrier (320) on the frame (350), and in that a deflecting mirror (M) is provided which deflects the light band (LB) sweeping over the upper side of the carrier (320) to the sensor (K6) fastened to the frame (350), and/or the light source (360) is arranged laterally below the carrier (320) on the frame (350) and a second deflection mirror deflects the light band (LB) over the carrier (320) over its upper side to the deflection mirror (M).

8. Receiving device (200) for components (B) according to one of the preceding claims, in which the sensor (K6) is designed as a black-and-white camera or as a color camera.

9. Receiving device (200) according to one of the preceding claims, in which an image-generating property and/or position sensor (K4) is provided for determining properties and/or the position of a component (B) to be received with respect to its properties and/or its position with respect to at least one of the receiving points (ES1, ES2), with the aim of generating correction instructions in the event of property and/or position errors of the component (B) to be received or of the receiving point, respectively of the receiving point by the control unit (ECU) for initiating corresponding corrective movements, and/or
in which the fourth rotary drive (DA4), controlled by control signals from the control unit (ECU), is set up to move the carrier (320) guided by the receiving device (200) in a controlled manner along one of the first and/or second axes (X-, Y-axis) by means of a mechanical traction, and/or
in which the third rotary drive (DA3), controlled by control signals from the control unit (ECU), is set up to rotate at least one of the receiving points (ES1, ES2) with the component receptacle of the carrier (320) located there in a controlled manner about the third axis (Z axis) containing the depositing points (ABS) as a function of signals from the imaging property and/or position sensor, and/or
in which the at least one linear drive is set up, controlled by control signals from the control unit (ECU), to move the receiving device (200) in a controlled manner by a part of the grid dimension of adjacent component receptacles of the carrier (320) along one of the first, second and/or third axes (X, Y, Z axis), and/or
in which the rotary drive (DA4) is set up to convey the carrier (320) guided by the receiving device (200) forwards along one of the first and/or second axes (X, Y axis) in accordance with a grid dimension of adjacent component receptacles of the carrier (320).

10. Receiving device (200) according to one of the preceding claims, wherein a suction and/or blow-out device (340) is provided in order to remove from at least one of the emission-receiving locations (ES1, ES2) in the receiving device (200) and/or the carrier (320) guided in the receiving device (200) a component (B) recognized as being defective and/or incorrectly placed, and/or
wherein the receiving device receives components from a turning device (150) whose axis of rotation is oriented substantially parallel to the conveying direction of the receiving device (200), or wherein the receiving device (200) receives components (B) from a turning device (150) whose axis of rotation is oriented substantially transversely to the conveying direction of the receiving device (200).

11. Receiving device (200) according to one of the claims 1 to 10, wherein in the center of the turning device (150) an imaging property and/or position sensor (K4) for determining properties and/or the position of a component to be received or for determining the position of receiving points (B) is provided. for determining the position of receiving points in the receiving device and/or of the component located therein, and which is arranged to carry out image feeds of at least one of the depositing points (ABS) or of the receiving points (ES1, ES2) in the receiving device (200) through between adjacent pick-ups (152) located on the periphery of the turning device (150).

12. Receiving device (200) according to one of the preceding claims, wherein the receiving device is to be moved relative to the deposit point (ABS) by means of a linear drive at least partially along a first axis (X-axis) in a controlled manner in both directions, and/or by means of a rotary drive (DA4) a carrier (320) guided by the receiving device (200) is to be moved along one of the first and/or second axes in a controlled manner in a conveying direction of the carrier (320), and the carrier (320) guided by the receiving device (200) is equipped with two receiving points (ES1, ES2) which are to be aligned at least approximately in alignment with a deposit point (ABS) for components (B) by controlled actuation of the drives, and an imaging property and/or position sensor (K4) supplies properties and/or position of a component to be examined with respect to its properties and/or its position in at least one of the receiving points (ES1, ES2) in the receiving device, wherein, based on image data from the property and/or position sensor, correction instructions in the event of property and/or position errors of the component are effected by a control unit (ECU) for initiating corresponding corrective movements of the receiving device (200) and/or of the carrier (320) guided therein, and a suction and/or blow-out device (340) is assigned to the receiving device (200) in order to remove from at least one of the receiving points (ES1, ES2) in the receiving device (200) and/or the carrier (320) guided in the receiving device (200) a component (B) which has been detected as being placed in a defective and/or faulty manner.

13. Receiving device (200) according to one of the preceding claims, wherein the suction position either coincides with the deposit point (ABS) or is provided at a position different from the second receiving point (ES2), upstream or downstream relative to the deposit point (ABS), and/or wherein the removal position (ABS) is located further from the second receiving point (ES2) than from the first receiving point (ES1) in the conveying direction of the carrier guided in the receiving device (200), and/or wherein the extraction and/or blow-out device (340) is arranged to be pivoted or moved from a retracted (rest) position towards the extraction position in order to remove a component (B) which is detected as being defectively and/or incorrectly placed.

14. A method of removing defective components (B) from a receiving device (200) according to claim 1, the method comprising the steps of:
- Detecting an improperly deposited component (B) in a pocket of the carrier (320) for a component (B) at the first receiving location (ES1),
- Moving the receiving device (200) by means of a linear drive (LA3) counter to the conveying direction so that the incorrectly deposited component (B) is located at a suction position without conveying the carrier (320) guided in the receiving device (200),
- Suctioning the improperly deposited component (B) at the suction position from the pocket of the carrier;
- Moving the receiving device (200) by means of the linear drive (LA3) in the conveying direction so that an empty pocket for a component (B) is located at the first receiving point (ES1) without conveying the carrier (320) guided in the receiving device (200),
Depositing a component (B) in the pocket of the carrier (320) at the first receiving point (ES1).

## Revendications

1. Dispositif de réception (200) pour des composants (B), qui est disposé de manière à pouvoir être réglé de manière contrôlée par rapport à un point de dépôt (ABS) au moyen d'au moins un entraînement linéaire (LA4) au moins partiellement le long d'un premier, d'un deuxième et/ou d'un troisième axe (axe X, Y, Z)
et/ou un entraînement (DA4) pour déplacer un support (320) guidé par le dispositif de réception (200) de manière contrôlée le long d'un des premier et/ou deuxième axes (axe X, Y), et le dispositif de réception comporte un capteur de position (K6) qui est assignié à un point de dépôt de composants (ABS), afin de détecter un composant (B) déposé seulement partiellement dans un poche du support (320) au point de dépôt de composants (ABS), le capteur de position (K6) étant relié latéralement par rapport au support (320) au dispositif de réception (200) de telle sorte que le capteur de position (K6) exécute directement les mouvements du dispositif de réception (200).

2. Dispositif récepteur (200) pour composants (B) selon la revendication 1, qui est agencé pour tourner de manière contrôlée au moyen d'un entraînement rotatif (DA3) au moins partiellement autour d'un troisième axe (axe Z) contenant le point de dépôt (ABS).

3. Dispositif de réception (200) pour composants (B) selon la revendication 1 ou 2, dans lequel le capteur (K6) exécute des mouvements du dispositif de réception (200) le long du premier axe (axe X), effectués par l'entraînement (LA3), et/ou le long du deuxième axe (axe Y), effectués par l'entraînement (LA4), et/ou autour du troisième axe (axe Z), effectués par l'entraînement (DA3), avec le dispositif de réception (200).

4. Dispositif de réception (200) pour des composants (B) selon l'une des revendications 1 - 3, dans lequel le capteur (K6) est relié de manière fixe à un cadre (350) du dispositif de réception (200), dans lequel le support (320) avec les poches pour la réception des composants (B) est guidé, afin de détecter un bord supérieur de la poche du support (320) guidé dans le cadre (350) au point de dépôt (ABS) par rapport à la position du composant (B).

5. Dispositif récepteur (200) pour composants (B) selon l'une quelconque des revendications précédentes, dans lequel le capteur (K6) est conçu comme un capteur de lumière en bande qui est disposé de manière fixe sur un côté du cadre (350) et est agencé pour détecter une bande de lumière (LB) provenant d'une source de lumière en bande (360) disposée sur le côté opposé du cadre (350).

6. Dispositif de réception (200) pour composants (B) selon la revendication 4 ou 5, dans lequel Sen-sor (K6) est agencé pour détecter, après que ladite bande lumineuse (LB) a balayé au moins approximativement parallèlement au côté supérieur du support (320) transversalement à la direction de transport du support (320) sur une longueur correspondant au moins à la dimension du sac dans la direction de transport, et pour évaluer ladite bande lumineuse détectée (LB) sur sa longueur, dans lequel la bande lumineuse (LB) est alignée avec le bord supérieur de la poche du support (320) guidé dans le cadre (350) au point de dépôt (ABS) de telle sorte qu'un composant (B) qui n'a pas été déposé complètement dans la poche du support (320) dépasse au moins partiellement de la poche et la bande lumineuse (LB) est par conséquent au moins partiellement occultée, et dans lequel le capteur K6 est agencé pour signaler ceci à une unité de commande (ECU).

7. Dispositif de réception (200) pour composants (B) selon l'une des revendications précédentes, dans lequel le capteur (K6) est disposé latéralement sous le support (320) sur le cadre (350), et en ce qu'il est prévu un miroir de renvoi (M) qui dévie la bande lumineuse (LB) balayant la face supérieure du support (320) vers le capteur (K6) fixé sur le cadre (350), et/ou la source lumineuse (360) est disposée latéralement sous le support (320) sur le cadre (350) et un second miroir de renvoi dévie la bande lumineuse (LB) sur le support (320) par sa face supérieure vers le miroir de renvoi (M).

8. Dispositif de réception (200) pour les composants (B) selon l'une des revendications précédentes, dans lequel le capteur (K6) est conçu comme un appareil photo noir et blanc ou comme un appareil photo couleur.

9. Dispositif de réception (200) selon l'une des revendications précédentes, dans lequel un capteur de propriété et/ou de position (K4) générateur d'images est prévu pour déterminer les propriétés et/ou la position d'un composant (B) à recevoir par rapport à ses propriétés et/ou sa position par rapport à au moins un des points de réception (ES1, ES2), dans le but de générer des instructions de correction en cas d'erreurs de propriété et/ou de position du composant (B) ou du point de réception par le contrôleur afin de lancer les mouvements correctifs correspondants, et/ou dans lequel le quatrième entraînement rotatif (DA4), actionné par des signaux de commande de l'unité de commande (ECU), est conçu pour déplacer de manière contrôlée le support (320) guidé par le dispositif récepteur (200) le long d'un des premier et/ou deuxième axes (axes X, Y) au moyen d'une traction mécanique, et/ou dans lequel le troisième entraînement rotatif (DA3), commandé par des signaux de commande de l'unité de commande (ECU), est réglé pour faire tourner, en fonction des signaux du capteur de propriété d'image et/ou du capteur de position, au moins l'un des points de réception (ES1, ES2) avec le support de composants du support (320) qui s'y trouve, de manière contrôlée, autour du troisième axe (axe Z) contenant les points de dépôt (ABS), et/ou
dans lequel l'entraînement rotatif (DA4) est adapté pour faire avancer le support (320) guidé par le dispositif de réception (200) le long de l'un des premier et/ou deuxième axes (X, Y) selon un pas des réceptacles de composants adjacents du support (320).

10. Dispositif de réception (200) selon l'une des revendications précédentes, dans lequel un dispositif d'aspiration et/ou de soufflage (340) est prévu pour enlever d'au moins un des emplacements d'émission-réception (ES1, ES2) dans le dispositif de réception (200) et/ou le support (320) guidé dans le dispositif d'émission-réception (200) un composant (B) détecté comme étant défectueux et/ou mal placé, et/ou dans lequel le dispositif de réception reçoit des composants d'un dispositif de rotation (150) dont l'axe de rotation est orienté sensiblement parallèlement à la direction de transport du dispositif de réception (200), ou dans lequel le dispositif de réception (200) reçoit des composants (B) d'un dispositif de rotation (150) dont l'axe de rotation est orienté sensiblement transversalement à la direction de transport du dispositif de réception (200).

11. Dispositif de réception (200) selon l'une des revendications 1 à 10, dans lequel il est prévu au centre du dispositif de retournement (150) un capteur de propriété et/ou de position (K4) pour déterminer des propriétés et/ou la position d'un composant à recevoir ou pour déterminer la position de points de réception dans le dispositif de réception et/ou d'un composant qui s'y trouve, et qui est agencé pour effectuer des capteurs d'au moins un des points de dépôt (ABS) ou des points de réception (ES1, ES2) dans le dispositif de réception (200) par l'intermédiaire de prises de vue adjacentes (152) situées sur la périphérie du dispositif de retournement (150).

12. Dispositif de réception (200) selon l'une des revendications précédentes, dans lequel le dispositif de réception doit être déplacé par rapport au point de dépôt (ABS) au moyen d'un entraînement linéaire au moins partiellement le long d'un premier axe (axe X) de manière contrôlée dans les deux directions, et/ou au moyen d'un entraînement rotatif (DA4), un support (320) guidé par le dispositif de réception (200) doit être déplacé le long de l'un des premier et/ou deuxième axes de manière contrôlée dans une direction de transport du support (320), et le support (320) guidé par le dispositif de réception (200) est équipé de deux points de réception (ES1, ES2) qui doivent être alignés au moins approximativement sur un point de dépôt (ABS) pour les composants (B) par actionnement contrôlé des entraînements, et un capteur d'imagerie de propriétés et/ou de position (K4) fournit les propriétés et/ou la position d'un composant à examiner en ce qui concerne ses propriétés et/ou sa position dans au moins un des points de réception (ES1, ES2) dans le dispositif de réception, dans lequel, sur la base des données d'image du capteur de propriété et/ou de position, des instructions de correction en cas d'erreurs de propriété et/ou de position du composant sont effectuées par une unité de commande (ECU) pour provoquer des mouvements correctifs correspondants du dispositif récepteur (200) et/ou du support (320) qui y est guidé, et un dispositif d'aspiration et/ou de soufflage (340) est associé au dispositif de réception (200) afin de retirer d'au moins un des points de réception (ES1, ES2) du dispositif de réception (200) et/ou du support (320) guidé dans le dispositif de réception (200) un composant (B) qui est détecté comme étant placé de manière défectueuse et/ou défectueuse.

13. Dispositif de réception (200) selon l'une quelconque des revendications précédentes, dans lequel la position d'aspiration soit coïncide avec le point de dépôt (ABS), soit est prévue à une position différente du deuxième point de réception (ES2), en amont ou en aval par rapport au point de dépôt (ABS), et/ou dans lequel la position d'extraction (ABS) est située plus loin du deuxième point de réception (ES2) que du premier point de réception (ES1) dans la direction de transport du support guidé dans le dispositif de réception (200), et/ou dans lequel le dispositif d'extraction et/ou de soufflage (340) est agencé pour être pivoté ou déplacé d'une position rétractée (de repos) vers la position d'extraction afin d'enlever un composant (B) qui est détecté comme étant défectueux et/ou mal placé.

14. Une méthode pour retirer les composants défectueux (B) d'un dispositif de réception (200) selon la revendication 1, la méthode comprenant les étapes suivantes
- Détecter d'un composant (B) mal déposé dans une poche du support (320) pour un composant (B) au premier lieu de réception (ES1),
- Déplacer le dispositif de réception (200) au moyen d'un entraînement linéaire (LA3) dans le sens inverse de la direction de transport, de sorte que la pièce mal déposée (B) se trouve en position d'aspiration sans transporter le support (320) guidé dans le dispositif de réception (200),
- Aspirer du composant (B) mal déposé à la position d'aspiration hors de la poche du support ;
- Déplacer le dispositif de réception (200) au moyen de l'entraînement linéaire (LA3) dans le sens du transport de telle sorte qu'une poche vide pour un composant (B) se trouve au premier point de réception (ES1) sans transporter le support (320) guidé dans le dispositif de réception (200),
Déposer d'un composant (B) dans la poche du porteur (320) au premier lieu de réception (ES1).
